(19) Europäisches Patentamt

European Patent Office

Office européen des brevets

(11) **EP 4 752 622 A1**

(12) **EUROPEAN PATENT APPLICATION**

(43) Date of publication:
03.06.2026 Bulletin 2026/23

(21) Application number: 25218118.5

(22) Date of filing: 24.11.2025

(51) International Patent Classification (IPC):
**G02B 27/10** (2006.01)  **G02B 27/28** (2006.01)

(52) Cooperative Patent Classification (CPC):
**G02B 27/1006; G02B 27/1086; G02B 27/283**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: 27.11.2024 JP 2024206299
26.09.2025 JP 2025160532

(71) Applicant: **NICHIA CORPORATION**
**Tokushima 774-8601 (JP)**

(72) Inventors:
• **DEJIMA, Norihiro**
**Anan-shi, Tokushima, 774-8601 (JP)**
• **OKAMOTO, Yoshio**
**Anan-shi, Tokushima, 774-8601 (JP)**

(74) Representative: **Betten & Resch**
**Patent- und Rechtsanwälte PartGmbB**
**Maximiliansplatz 14**
**80333 München (DE)**

(54) **WAVELENGTH BEAM COMBINING DEVICE, DIRECT DIODE LASER DEVICE, AND LASER PROCESSING MACHINE**

(57) A wavelength beam combining device includes: a plurality of laser light sources configured to emit a plurality of laser beams in a first direction and having mutually different peak wavelengths and central axes arranged in a second direction intersecting the first direction; a first diffraction grating disposed at a position where the plurality of laser beams are received, the first diffraction grating being configured to diffract the plurality of laser beams in different directions according to wavelengths of the laser beams to cause the diffracted laser beams to enter the second diffraction grating; a second diffraction grating configured to diffract the plurality of laser beams diffracted by the first diffraction grating to form a wavelength-combined beam, and to direct the wavelength-combined beam in the first direction; and an optical coupling unit configured to couple the wavelength-combined beam to an optical transmission fiber and to be movable in the second direction.

*FIG.1*

## Description

CROSS-REFERENCE TO RELATED APPLICATION

This application claims priority to Japanese Patent Application No. 2024-206299, filed on November 27, 2024, the disclosure of which is hereby incorporated by reference in its entirety.

TECHNICAL FIELD

The present disclosure relates to a wavelength beam combining device, a direct diode laser device, and a laser processing machine.

BACKGROUND

High-power and high-brightness laser beams are used to perform processing such as cutting, drilling, and marking on various types of materials or weld metal materials. Some carbon dioxide gas laser devices and YAG solid-state laser devices used for such laser processing in the related art are being replaced with fiber laser devices with high energy conversion efficiency. A laser diode (hereinafter, simply referred to as an LD) is used for a pump light source of the fiber laser device. In recent years, with increasing output of the LD, technology has been developed to use the LD not as the pump light source but as a light source of a laser beam with which a material is directly irradiated and processed. Such technology is referred to as direct diode laser (DDL) technology.

Japanese Patent Publication No. 2012-508453 discloses a multi-wavelength beam combiner including a laser stack having a plurality of laser arrays, each of which emits a light beam having an own specific wavelength, a cylindrical telescope, a conversion lens that intercepts light beams from each of the plurality of laser arrays and combines the light beams along a stacking dimension of the laser stack to form a multi-wavelength light beam, and a diffractive element located in an overlap region of the light beams. Co-axial combining of a plurality of laser beams having mutually different wavelengths is referred to as "wavelength beam combining (WBC)" or "spectral beam combining (SBC)," and may be used to increase the light output and brightness of, for example, a DDL device.

Japanese Patent Publication No. 2021-158302 discloses a laser oscillator including a plurality of laser modules that emit laser light. The laser oscillator includes a Peltier control unit that individually controls the temperature of each of the plurality of laser modules. The wavelength of the laser light emitted from the laser module is shifted under the temperature control by the Peltier control unit. This allows a locked wavelength and a gain wavelength to coincide with each other, so that the maximum value of a gain at the locked wavelength of the laser module is obtained and laser output can be increased.

SUMMARY

An object of the present disclosure is to provide a wavelength beam combining device, a direct diode laser device, and a laser processing machine that can increase coupling efficiency when a wavelength-combined beam is coupled to an optical transmission fiber.

In an embodiment, a wavelength beam combining device is configured to combine a plurality of laser beams emitted from a laser light source in a first direction, having mutually different peak wavelengths, and having central axes arranged side by side in a second direction intersecting the first direction, the wavelength beam combining device including: a first diffraction grating and a second diffraction grating, the first diffraction grating being disposed at a position where the plurality of laser beams are received, the first diffraction grating being configured to diffract the plurality of laser beams in different directions according to wavelengths to cause the diffracted laser beams to enter the second diffraction grating, the second diffraction grating being configured to further diffract the plurality of laser beams diffracted by the first diffraction grating to form a wavelength-combined beam, and to cause the wavelength-combined beam to exit in the first direction; and an optical coupling unit configured to couple the wavelength-combined beam to an optical transmission fiber and to be movable in the second direction.

In an embodiment, a direct diode laser device of the present disclosure includes: the wavelength beam combining device described above; a plurality of semiconductor laser devices configured to emit laser beams having mutually different peak wavelengths; and an optical fiber array configured to form the plurality of laser beams to be incident on the collimator of the wavelength beam combining device from the plurality of laser beams emitted from the plurality of semiconductor laser devices.

A laser processing machine of the present disclosure includes: at least one direct diode laser device described above; an optical transmission fiber coupled to the wavelength-combined beam emitted from the at least one direct diode laser device; and a processing head connected to the optical transmission fiber.

Certain embodiments of the present disclosure can provide a wavelength beam combining device, a direct diode laser device, and a laser processing machine that can increase coupling efficiency when a wavelength-combined beam is coupled to an optical transmission fiber.

BRIEF DESCRIPTION OF DRAWINGS

FIG. 1 is a plan view schematically illustrating a configuration example of a device for coaxially combining a plurality of laser beams having mutually different peak wavelengths as seen along a direction perpendicular to an XZ plane.

FIG. 2 is a schematic view illustrating an incident angle α of a laser beam incident on a diffraction grating illustrated in FIG. 1 and a diffraction angle β of reflected diffracted light.

FIG. 3A is a graph illustrating a gain spectrum and an output spectrum of an external cavity LD in a state in which a locked wavelength and a gain peak are matched with each other.

FIG. 3B is a graph illustrating the gain spectrum and the output spectrum of the external cavity LD in a state in which the gain spectrum is shifted to a long-wavelength side, and the locked wavelength and the gain peak are not matched with each other.

FIG. 3C is a graph illustrating the gain spectrum and the output spectrum of the external cavity LD in a state in which the gain spectrum is shifted to a short-wavelength side, and the locked wavelength and the gain peak are not matched with each other.

FIG. 3D is a graph illustrating an output spectrum of a distributed feedback LD or a distributed Bragg reflector LD.

FIG. 4 is a schematic view for explaining a decrease in coupling efficiency due to the occurrence of a wavelength shift.

FIG. 5 is a graph illustrating the relationship between a wavelength shift amount and the coupling efficiency.

FIG. 6 is a plan view schematically illustrating a configuration of a wavelength beam combining device according to a first embodiment of the present disclosure as seen along the direction perpendicular to the XZ plane.

FIG. 7 is a schematic view illustrating a first implementation example of an optical coupling unit.

FIG. 8 is a plan view schematically illustrating another configuration of a wavelength beam combining device according to the first embodiment of the present disclosure as seen along the direction perpendicular to the XZ plane.

FIG. 9 is a schematic view illustrating a second implementation example of the optical coupling unit.

FIG. 10 is a plan view schematically illustrating still another configuration of the wavelength beam combining device according to the first embodiment of the present disclosure as seen along the direction perpendicular to the XZ plane.

FIG. 11 is a plan view schematically illustrating a configuration of a wavelength beam combining device according to a second embodiment of the present disclosure as seen along the direction perpendicular to the XZ plane.

FIG. 12 is a schematic view illustrating a third implementation example of the optical coupling unit.

FIG. 13 is a plan view schematically illustrating a configuration of a wavelength beam combining device according to a third embodiment of the present disclosure as seen along the direction perpendicular to the XZ plane.

FIG. 14 is a plan view schematically illustrating a configuration of the wavelength beam combining device according to the third embodiment of the present disclosure as seen along a direction perpendicular to a YZ plane.

FIG. 15 is a view schematically illustrating a configuration example of a beam reducer having a Galilean lens configuration.

FIG. 16 is a view schematically illustrating another configuration example of the beam reducer having a Galilean lens configuration.

FIG. 17A is a schematic view for explaining a divergence angle of a laser beam on the XZ plane.

FIG. 17B is a schematic view for explaining a divergence angle of a laser beam on the YZ plane.

FIG. 18 is a plan view schematically illustrating another configuration of a wavelength beam combining device according to the third embodiment of the present disclosure as seen along the direction perpendicular to the XZ plane.

FIG. 19 is a plan view schematically illustrating another configuration of the wavelength beam combining device according to the third embodiment of the present disclosure as seen along the direction perpendicular to the YZ plane.

FIG. 20 is a plan view schematically illustrating a configuration of a wavelength beam combining device according to a fourth embodiment of the present disclosure as seen along the direction perpendicular to the XZ plane.

FIG 21. is a graph showing the measurement results of optical output when the optical coupling unit is moved in a predetermined direction.

FIG. 21B is a graph showing the measurement results of combining efficiency when the optical coupling unit is moved in a predetermined direction.

FIG. 22A is a graph showing the measurement results of optical output when the moving unit is moved in a predetermined direction.

FIG. 22B is a graph showing the measurement results of combining efficiency when the moving unit is moved in a predetermined direction.

FIG. 23 is a plan view schematically illustrating a configuration of a direct diode laser device according to an embodiment of the present disclosure as seen along the direction perpendicular to the XZ plane.

FIG. 24 is a plan view schematically illustrating another configuration of the direct diode laser device according to an embodiment of the present disclosure as seen along the direction perpendicular to the XZ plane.

FIG. 25 is a view illustrating a configuration example of a processing machine according to an embodiment of the present disclosure.

DETAILED DESCRIPTION

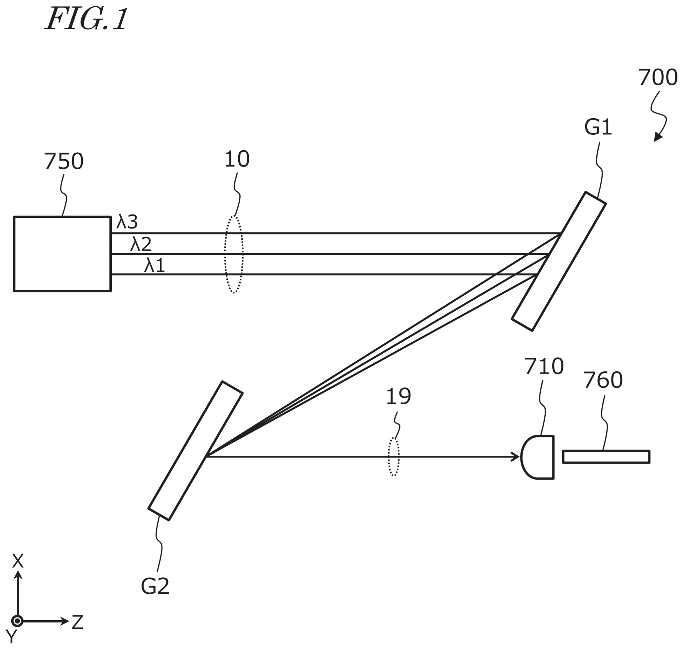

Before describing embodiments of the present disclosure, an overview of wavelength beam combining using two diffraction gratings is described with reference to FIGS. 1 to 5. In the accompanying drawings, an X-axis, a Y-axis, and a Z-axis orthogonal to one another are shown for reference.

FIG. 1 is a plan view schematically illustrating a configuration example of a device for coaxially combining a plurality of laser beams having mutually different peak wavelengths as seen along a direction perpendicular to an XZ plane. FIG. 1 illustrates an example of combining three laser beams 10 having peak wavelengths λ1, λ2, and λ3. In the present specification, a device that coaxially combines a plurality of laser beams having mutually different peak wavelengths is referred to as a "wavelength beam combining device." Hereinafter, the peak wavelengths of the plurality of laser beams 10 to be combined may be denoted by λn. Where "n" is an integer equal to or larger than 1 and is used as a numerical value for distinguishing (specifying) each of the plurality of laser beams 10. In the illustrated example, a relationship of λ1 < λ2 < λ3 is established. The unit of the peak wavelength λn is optional, and is, for example, nanometer (nm).

In FIG. 1, each of the plurality of laser beams 10 is indicated by a simple straight line. The actual laser beam 10 is a light beam having an intensity distribution in a plane perpendicular to a traveling direction. The intensity distribution can be approximated by a distribution function such as a Gaussian distribution in a plane orthogonal to the traveling direction of the light beam. The diameter of the light beam is defined, for example, by the size of a cross-sectional area having an intensity $1/e^2$ or more times the intensity at the center of the beam. In the drawing, to schematically illustrate the traveling direction of a light beam such as a laser beam or a wavelength-combined beam, the central axis of each light beam is represented by a straight line. These straight lines may be considered to indicate light rays passing through the center of each light beam.

A wavelength beam combining device 700 illustrated in FIG. 1 includes a pair of diffraction gratings G1 and G2 disposed in parallel and a converging lens 710. A first diffraction grating G1 is disposed at a position where the plurality of laser beams 10 emitted from a laser light source 750 are received, and diffracts the plurality of laser beams 10 in different directions according to the wavelengths to cause the diffracted laser beams to enter a second diffraction grating G2. The second diffraction grating G2 further diffracts the plurality of laser beams 10 diffracted by the first diffraction grating G1 to form a wavelength-combined beam 19, and causes the wavelength-combined beam 19 to enter the converging lens 710. The converging lens 710 converges the wavelength-combined beam 19 and couples the converged wavelength-combined beam 19 to an optical transmission fiber 760. The wavelength beam combining device can increase a laser beam output while maintaining the beam quality. The beam quality can be expressed by BPP [mm·mrad] that is the product of a beam waist radius (ω0) and a half angle (θ) of a beam divergence angle. A smaller BPP indicates a higher beam quality.

The principle of wavelength beam combining using two diffraction gratings, and various examples of the configuration of a wavelength beam combining device are described in detail in, for example, Japanese Patent Publication No. 2023-088438 or Japanese Patent Publication No. 2024-172262, each of which is a Japanese application filed by the present applicant. The entire disclosures of Japanese Patent Publication No. 2023-088438 and Japanese Patent Publication No. 2024-172262 are incorporated herein by reference.

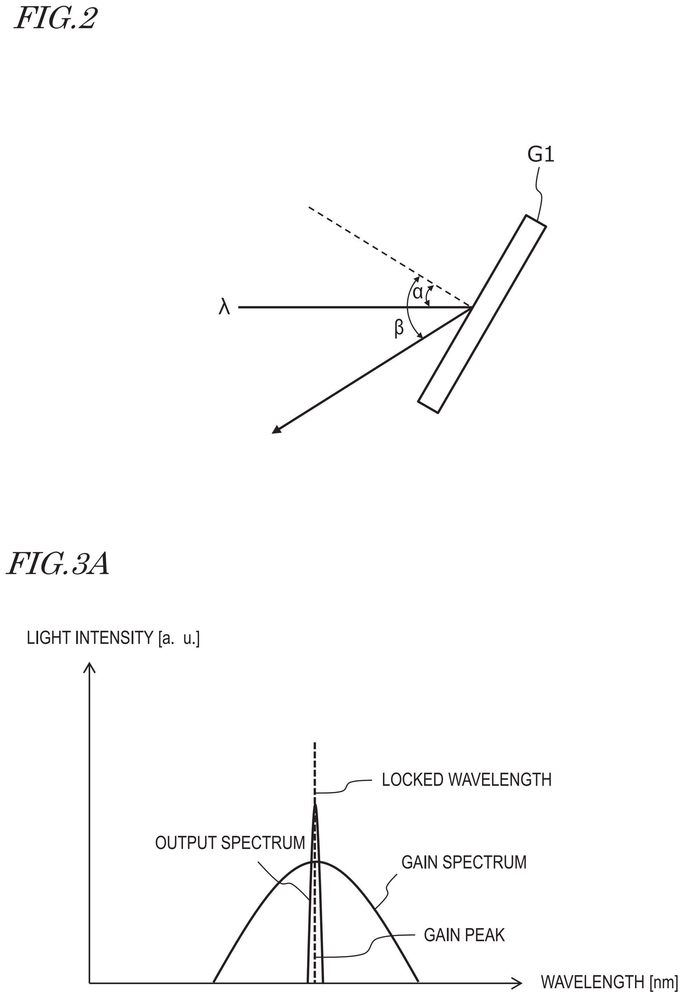

FIG. 2 is a schematic view illustrating an incident angle α of a laser beam incident on the diffraction grating G1 illustrated in FIG. 1, and a diffraction angle β of reflected diffracted light. The incident angle α is an angle formed by the central axis of the laser beam relative to the normal direction of the diffraction grating G1 indicated by the broken line. The diffraction angle β is a diffraction angle of reflected diffracted light formed by the laser beam with the wavelength λ incident on the diffraction grating G1. The relationship of the following mathematical expression 1 is established between the incident angle α and the diffraction angle β.

$$[\text{Math.} \quad 1]$$

$$\text{Sin}\alpha + \sin\beta = N \cdot m \cdot \lambda$$

Where N is the number of grooves per unit length (for example, 1 mm) of the diffraction grating G1, and m is a diffraction order. The number of grooves N per unit length is the reciprocal of a grating groove period. As can be seen from mathematical expression 1 above, when the incident angle α is constant, the diffraction angle β changes as the wavelength λ of the laser beam incident on the diffraction grating G1 changes.

A wavelength-controlled light source is used for the wavelength beam combining. As a wavelength-controlled light source, an external cavity laser diode (EC-LD), a distributed feedback laser diode (DFB-LD), a distributed Bragg reflector laser diode (DBR-LD), or the like can be used.

The relationship between a designed wavelength and an actual wavelength of the wavelength-controlled light source is described with reference to FIGS. 3A to 3D.

First, a gain spectrum and an output spectrum of the external cavity LD are described.

The external cavity LD is less susceptible to the ambient temperature or the operating temperature of the LD because an external cavity mirror is literally disposed outside the LD. This results in a small variation in locked wavelength. However, because the gain spectrum varies depending on the ambient temperature or the operating temperature of the LD, an increase or decrease in output is significant.

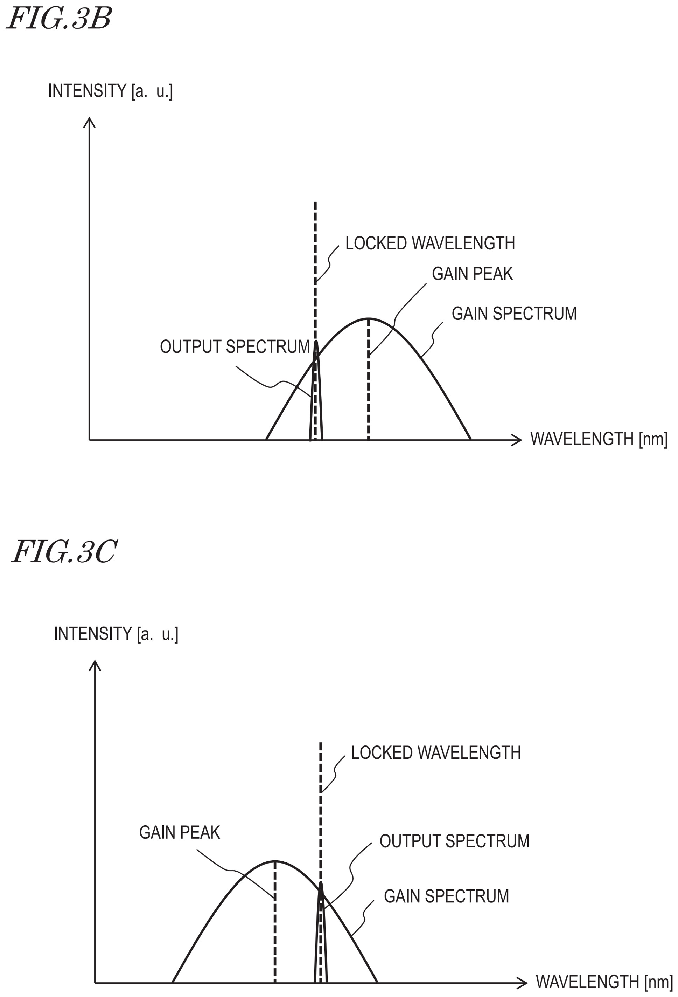

FIG. 3A is a graph illustrating a gain spectrum and an output spectrum in a state in which a locked wavelength and a gain peak are matched with each other. FIG. 3B is a graph illustrating the gain spectrum and the output spectrum in a state in which the gain spectrum is shifted to a long-wavelength side, and the locked wavelength and the gain peak are not matched with each other. FIG. 3C is a graph illustrating the gain spectrum and the output spectrum in a state in which the gain spectrum is shifted to a short-wavelength side, and the locked wavelength and the gain peak are not matched with each other.

The gain peak is a peak wavelength of the gain spectrum. The locked wavelength can be referred to as a designed wavelength of a laser beam. Due to the characteristics of the LD, for example, when the ambient temperature or the operating temperature of the LD rises due to heating, the gain spectrum is shifted to the long-wavelength side, whereas when the ambient temperature or the operating temperature of the LD falls due to cooling, the gain spectrum is shifted to the short-wavelength side.

In the present specification, shifting of the output spectrum or the gain peak to the long-wavelength side or the short-wavelength side is referred to as "wavelength shift." The wavelength shift may occur due to various factors. These factors are described in detail below.

In the case of the external cavity LD, in a state in which the locked wavelength and the gain peak are matched with each other, in other words, in a state in which the locked wavelength and the gain peak coincide with each other, a laser beam having a relatively high output is emitted from the LD. On the other hand, in a state in which the locked wavelength and the gain peak are not matched with each other due to the occurrence of the wavelength shift, a laser beam having a relatively low output is emitted from the LD. In Japanese Patent Publication No. 2021-158302, gain spectra of a plurality of laser modules are individually controlled to bring the gain peak closer to the locked wavelength, thereby achieving a higher laser output. However, because each of the plurality of laser modules needs to be individually controlled, a plurality of cooling devices are required. As a result, increases in size, complication, and cost of the system are inevitable.

An output spectrum of the distributed feedback LD or the distributed Bragg reflector LD is described below.

In contrast to the external cavity LD, the distributed feedback LD or the distributed Bragg reflector LD is easily affected by the ambient temperature or the operating temperature of the LD because a diffraction grating is provided inside the LD. This results in a large variation in the locked wavelength. However, because the distributed feedback LD or the distributed Bragg reflector LD is affected by the ambient temperature or the operating temperature similarly to the external cavity LD, an increase or decrease in output is insignificant.

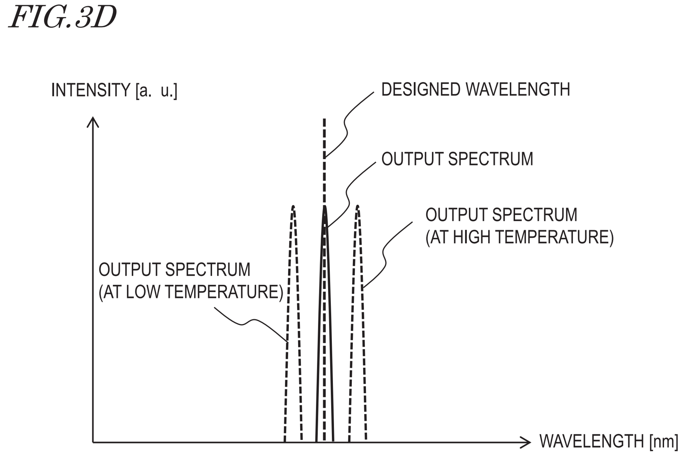

FIG. 3D is a graph illustrating the output spectrum of the distributed feedback LD or the distributed Bragg reflector LD. For example, when the ambient temperature or the operating temperature of the LD rises due to heating, the output spectrum is shifted to the long-wavelength side, whereas when the ambient temperature or the operating temperature of the LD falls due to cooling, the output spectrum is shifted to the short-wavelength side. An increase or decrease in the output of a laser beam due to the wavelength shift is less significant compared to the external cavity LD.

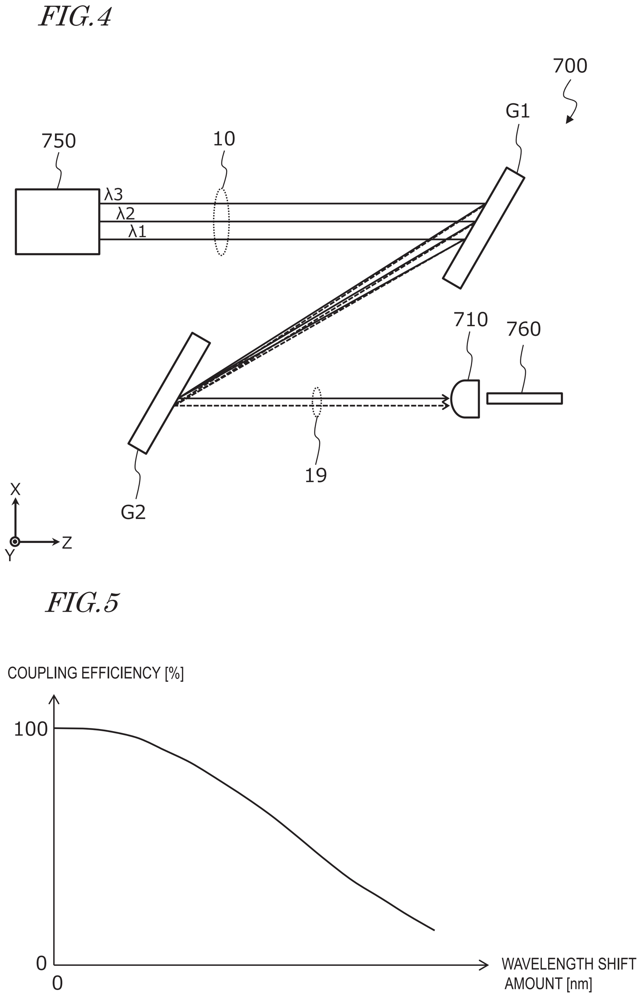

FIG. 4 is a schematic view for explaining a decrease in coupling efficiency due to the occurrence of a wavelength shift in the present embodiment. In FIG. 4, laser beams traveling at the designed wavelengths are indicated by solid lines, and laser beams whose wavelength has been shifted to the long-wavelength side are indicated by dotted lines. FIG. 1 illustrates how laser beams travel at the designed wavelengths. As described above, when the wavelength λ of the laser beam incident on the diffraction grating changes, the diffraction angle changes. Accordingly, when the wavelength shift occurs, the diffraction angle changes, resulting in a change in a spot (intersection of the central axes of the laser beams) on the diffraction grating G2 on which the reflected diffracted light is incident, as illustrated in FIG. 4. On the other hand, the wavelength-combined beam 19 formed by the diffraction grating G2 due to the wavelength shift travels in the same direction as the emission direction of the wavelength-combined beam 19 in a state in which no wavelength shift occurs. In other words, because the angle of the light reflected and diffracted by the diffraction grating G2 does not change even though the wavelength shift has occurred, the central axis of the wavelength-combined beam 19 indicated by the straight line, and the central axis of the wavelength-combined beam 19 indicated by the dotted line are parallel to each other. However, the central axis of the wavelength-combined beam 19 indicated by the dotted line is shifted in an X-axis direction with reference to the central axis of the wavelength-combined beam 19 indicated by the straight line. Specifically, when the output spectrum is shifted to the long-wavelength side, the central axis of the wavelength-combined beam 19 indicated by the dotted line is shifted from the central axis of the wavelength-combined beam 19 indicated by the straight line in the negative X-axis direction. On the other hand, when the output spectrum is shifted to the short-wavelength side, the central axis of the wavelength-combined beam 19 indicated by the dotted line is shifted in parallel to the positive X-axis direction from the central axis of the wavelength-combined beam 19 indicated by the straight line.

FIG. 5 is a graph illustrating a relationship between a wavelength shift amount and coupling efficiency. A horizontal axis indicates the wavelength shift amount [nm], and a vertical axis indicates the coupling efficiency [%]. Assuming that the coupling efficiency when no wavelength shift occurs, that is, a wavelength shift amount indicating a change amount $\Delta\lambda$ of an output spectrum is zero, is set to 100%, the coupling efficiency decreases as the wavelength shift amount increases.

The shift amount of the central axis of a wavelength-combined beam in the X-axis direction depends on an optical system for wavelength beam combining. Specifically, the shift amount varies depending on an interval between a pair of diffraction gratings, the number of grooves N of the diffraction grating, or an incident angle of a laser beam incident on the diffraction grating. For example, when the output spectrum changes by 0.1 nm, the shift amount of the center axis of the wavelength-combined beam in the X-axis direction may be about several tens of micrometers. In this case, the coupling efficiency may be reduced by 50% or more as compared with when no wavelength shift occurs. A large shift amount of the central axis of the wavelength-combined beam may lead to damage to an optical member. For example, a wavelength-combined beam that originally needs to enter a core portion of an optical transmission fiber enters a clad portion, and as a result, a coating layer or a jacket layer on the outer periphery of the clad may be broken.

A wavelength beam combining device according to an embodiment of the present disclosure includes an optical coupling unit that couples a wavelength-combined beam to an optical transmission fiber. The optical coupling unit is configured to be movable in the shift direction of a central axis of the wavelength-combined beam. For example, even though the ambient temperature or the operating temperature of a laser light source rises, and the central axis of the wavelength-combined beam is shifted, a decrease in the coupling efficiency of the optical transmission fiber can be suppressed by moving the optical coupling unit in the shift direction.

A wavelength beam combining device, a direct diode laser device, and a laser processing machine according to embodiments of the present disclosure are described below in detail with reference to the drawings. Parts having the same reference characters appearing in the plurality of drawings indicate the same or similar parts. The description of the dimensions, materials, shapes, relative arrangements, and the like of components are intended to be illustrative rather than limiting the scope of the present invention. The size, positional relationship, and the like of the members illustrated in the drawings may be exaggerated to facilitate understanding and the like.

## 1. First Embodiment of Wavelength Beam Combining Device

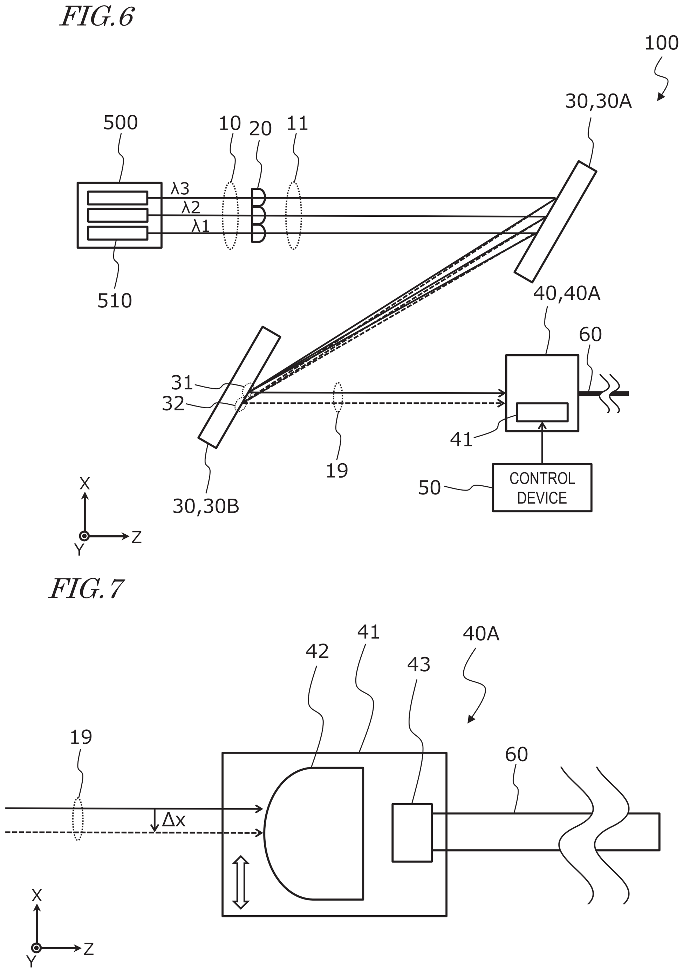

FIG. 6 is a plan view schematically illustrating a configuration of a wavelength beam combining device according to a first embodiment of the present disclosure as seen along the direction perpendicular to the XZ plane. In FIG. 6, a state in which a laser beam travels when no wavelength shift occurs is indicated by a solid line, and a state in which a laser beam travels when the wavelength shift has occurred is indicated by a dotted line.

A wavelength beam combining device 100 illustrated in FIG. 6 can combine a plurality of laser beams 10 emitted from a laser light source 500 and having mutually different peak wavelengths. For the sake of simplicity, FIG. 6 illustrates a configuration example of a device for coaxially combining three laser beams 10 having peak wavelengths of $\lambda 1$, $\lambda 2$, and $\lambda 3$. The number of laser beams 10 to be combined is not limited to three, and two or four or more laser beams 10 having mutually different peak wavelengths may be combined. As described below, the laser beam 10 may be collimated by an optical system such as a collimator lens (hereinafter, simply referred to as "collimator"). The collimated $1/e^2$ beam diameter is, for example, 1 mm to 30 mm, and is smaller than the spacing between adjacent collimators.

In the example illustrated in FIG. 6, the laser light source 500 includes a plurality of semiconductor laser devices 510 that emit beams of laser light having mutually different peak wavelengths. The laser light source 500 may include a laser bar as described below. The laser beams having peak wavelengths of $\lambda 1$, $\lambda 2$, and $\lambda 3$ are emitted from the plurality of semiconductor laser devices 510. The plurality of semiconductor laser devices 510 may be configured to oscillate in single longitudinal modes with mutually different peak wavelengths. The peak wavelengths fall within, for example, a range from 430 nm to 480 nm.

The laser light source 500 is controlled so that the amounts of currents input to the plurality of semiconductor laser devices 510 are equal. Examples of the semiconductor laser device 510 include an external cavity LD, a distributed feedback LD, and a distributed Bragg reflector LD. The external cavity LD includes, for example, a surface relief grating (SRG) or a volume holographic grating (VHG) as a member necessary for external resonance. Such a type of semiconductor laser device can narrow the output spectrum of the laser beam, that is, control the wavelengths, by adjustment in the laser light source 500, as illustrated in FIGS. 3A to 3D.

The wavelength beam combining device 100 illustrated in FIG. 6 includes a pair of diffraction gratings 30 disposed in parallel and an optical coupling unit 40. The wavelength beam combining device 100 combines a plurality of laser beams emitted in a first direction, having mutually different peak wavelengths, and having central axes arranged in a second direction intersecting the first direction. In the example illustrated in FIG. 6, the first direction is parallel to a Z-axis direction, and the second direction is parallel to the X-axis direction. In the illustrated example, the second direction is orthogonal to the first direction. In the present disclosure, unless otherwise specified, the first direction is parallel to the Z-axis direction, and the second direction is parallel to the X-axis direction.

The wavelength beam combining device 100 illustrated in FIG. 6 further includes a collimator 20 for converting the plurality of laser beams 10 into a plurality of collimated beams 11. The three laser beams 10 whose central axes are parallel to one another enter the collimator 20. The collimator 20 is configured to convert the plurality of laser beams 10 having mutually different peak wavelengths into the plurality of collimated beams 11. The collimator 20 is an assembly of collimator lenses. The collimator 20 may be a lens array in which lenses equal in number to the plurality of laser beams 10 are formed of one optical member, or may be an optical component assembly in which a plurality of lenses are arranged. The collimated beam 11 transmitted through the collimator 20 and having a small divergence angle is not strictly parallel light, but is approximated to a Gaussian beam in which the product of a divergence angle and a beam diameter has a finite value. The optical material of the collimator 20 may be an optical glass such as synthetic silica or BK7. The optical glass is a glass material having a high transmittance for visible light.

The pair of diffraction gratings 30 illustrated in FIG. 6 include first and second diffraction gratings 30A and 30B disposed in parallel between the collimator 20 and the optical coupling unit 40. Each of the first and second diffraction gratings 30A and 30B is a transmissive diffraction grating. However, the diffraction gratings 30 may be reflective diffraction gratings. In the present embodiment, a diffraction grating of a type in which both reflected light reflected by the diffraction grating and transmitted light transmitted through the diffraction grating are present is referred to as a "transmissive diffraction grating," and a diffraction grating of a type in which no transmitted light is present is referred to as a "reflective diffraction grating."

Unlike the transmissive diffraction grating, the reflective diffraction grating includes a member (for example, a metal mirror) for reflection, and light absorption by the member is not negligible. Therefore, in the reflective diffraction grating, when the intensity of an incident laser beam is increased, heat generation due to light absorption may deteriorate the performance of the diffraction grating or cause a breakage of the diffraction grating. Therefore, the present embodiment desirably uses the transmissive diffraction grating. A base body of the diffraction grating 30 may be formed of a material having a low absorptance at the peak wavelength of the laser beam, for example, synthetic silica. The cross-sectional shape of the grating is, for example, rectangular or trapezoidal. As described below, transmitted light can also be used rather than reflected light from the transmissive diffraction grating.

The degree of parallelism between the first diffraction grating 30A and the second diffraction grating 30B is evaluated by an angle between a first normal line to a surface of the first diffraction grating 30A where diffraction grooves are formed and a second normal line to a surface of the second diffraction grating 30B where diffraction grooves are formed. In the present embodiment, the angle between the first normal line and the second normal line is preferably in a range of 180° ± 1°.

The first diffraction grating 30A is disposed at a position where the plurality of laser beams 10 are received, and diffracts the plurality of laser beams 10 in different directions according to the wavelengths to cause the plurality of laser beams 10 to enter the second diffraction grating 30B. The second diffraction grating 30B further diffracts the plurality of laser beams 10 diffracted by the first diffraction grating 30A to form a wavelength-combined beam 19, and directs the wavelength-combined beam 19 in the first direction. In the example illustrated in FIG. 6, the first diffraction grating 30A is disposed at a position where the plurality of collimated beams 11 exiting from the collimator 20 are received, and diffracts the plurality of collimated beams 11 in different directions according to the wavelengths to cause the plurality of collimated beams 11 to enter the region 31 that is a certain region of the second diffraction grating 30B. The second diffraction grating 30B further diffracts, in the region 31, the plurality of collimated beams 11 diffracted by the first diffraction grating 30A to form a wavelength-combined beam 19, and directs the wavelength-combined beam 19 in the first direction.

In the present embodiment, the first diffraction grating 30A and the second diffraction grating 30B have substantially the same structure. The first diffraction grating 30A and the second diffraction grating 30B are disposed such that the extending direction of the diffraction grooves of the first diffraction grating 30A, and the extending direction of the diffraction grooves of the second diffraction grating 30B are parallel to each other. More specifically, the normal line of the first diffraction grating 30A and the normal line of the second diffraction grating 30B are parallel to each other, and the extending direction of the diffraction grooves of the first diffraction grating 30A and the extending direction of the diffraction grooves of the second diffraction grating 30B are parallel to each other. In the example illustrated in FIG. 6, the extending direction of the diffraction grooves of each of the first diffraction grating 30A and the second diffraction grating 30B is parallel to a Y-axis direction. The dispersion direction (XZ plane) of the first diffraction grating 30A and the dispersion direction (XZ plane) of the second diffraction grating 30B can also be described as being the same. The diffraction groove period (interval between the centers of the diffraction grooves) of the first diffraction grating 30A is equal to the diffraction groove period (interval between the centers of the diffraction grooves) of the second diffraction grating 30B. Such a configuration is adopted, and thus the wavelength-combined beam 19 can be emitted in the first direction parallel to the exiting direction of each collimated beam 11. In the example illustrated in FIG. 6, the emission direction of the plurality of laser beams 10, the exiting direction of the plurality of collimated beams 11, the direction directed by the wavelength-combined beam 19 are parallel to one another.

The wavelength-combined beam 19 may be a laser beam obtained by wavelength combining of n laser beams 10 having peak wavelengths of $\lambda 1$, $\lambda 2$,..., $\lambda n$ ("..."indicates any number of wavelengths between $\lambda 2$ and $\lambda n$ in sequence). The beam quality of the wavelength-combined beam 19 in which the plurality of laser beams 10 are coaxially superimposed is substantially equivalent to the beam quality of each laser beam 10. The light intensity of the wavelength-combined beam 19 is equal to the sum of the light intensities of the laser beams 10. As the number of laser beams 10 to be combined is increased, the output and power density of the wavelength-combined beam 19 can be increased in proportion to the number of the laser beams 10.

As mentioned above, the wavelength shift of the laser beam emitted from the laser light source 500 may occur due to various factors. Representative factors include, for example, an input current (or an applied current) input to the semiconductor laser device, the temperature of the semiconductor laser device, or deterioration over time. The temperature of the semiconductor laser device may be managed as a temperature parameter such as the ambient temperature or the operating temperature of the device. In the present embodiment, the input current, the ambient temperature, the operating temperature, the degradation over time, and the like are defined as "the operating state of a laser light source."

Depending on the operating state of the laser light source, a wavelength shift may occur in the laser light source 500. For example, when the input current increases, the operating temperature of the semiconductor laser device rises, causing a wavelength shift to the long-wavelength side. Alternatively, when the ambient temperature rises, the operating temperature of the semiconductor laser device rises, causing a wavelength shift to the long-wavelength side. When the semiconductor laser device deteriorates over time, a threshold current increases, and the operating temperature of the semiconductor laser device rises, causing a wavelength shift to the long-wavelength side. In this way, as the operating state of the laser light source 500 is changed, the wavelength shift occurs, resulting in a change in the diffraction angle of the reflected diffracted light diffracted by the first diffraction grating 30A. When the diffraction angle of the reflected diffracted light is changed, the spot on the second diffraction grating 30B on which the reflected diffracted light is incident moves from the region 31 to a region 32 on the XZ plane. As a result, the central axis of the wavelength-combined beam 19 is shifted in the second direction (direction parallel to the X-axis).

The optical coupling unit 40 optically couples the wavelength-combined beam 19 to an optical transmission fiber 60. The optical coupling unit 40 is configured to be movable in the second direction. In the present embodiment, the shift direction of the central axis of the wavelength-combined beam 19 when the wavelength shift has occurred is a direction parallel to the X-axis and is constant. In addition, the shift direction and the shift amount of the central axis of the laser beam can be predicted from the driving conditions of the semiconductor laser device. Accordingly, when the central axis of the wavelength-combined beam 19 is shifted in the second direction according to the operating state of the laser light source 500, the optical coupling unit 40 is moved in the shift direction of the central axis of the laser beam by a predicted shift amount, so that a decrease in the coupling efficiency of the optical transmission fiber 60 can be suppressed.

The optical coupling unit 40 has a movable stage 41 that moves, in response to a signal defining a shift amount determined based on the operating state of the laser light source 500, the optical coupling unit 40 in the second direction by the shift amount. An example of the movable stage 41 is an automatic stage having an electric motor. The movable stage 41 may be connected by wire or wirelessly to a dedicated controller for controlling the automatic stage. In the present embodiment, the automatic stage alone or a combination of the automatic stage and the controller can function as a movable stage for moving the optical coupling unit 40. For example, a uniaxial automatic stage is used, and thus the optical coupling unit 40 can be moved in at least the second direction.

A control device 50 is connected by wire or wirelessly to the movable stage 41. The control device 50 is configured or programmed to determine the shift amount of the optical coupling unit 40 based on the operating state of the laser light source 500, and to transmit a signal defining the shift amount to the movable stage 41. The control device 50 includes at least one processor and at least one memory that stores a computer program (or software) defining a control process to be performed by the processor. An example of the control device 50 is a computing device such as a personal computer (PC). In the present embodiment, the control device 50 determines the shift amount of the central axis of the wavelength-combined beam 19 according to the input current input to the semiconductor laser device, which is set by a user. As another example, based on an L-I characteristic curve indicating a relationship between the output of an LD and a drive current, the control device 50 can measure the drive current from the output of laser light measured by a power meter. The control device 50 can determine the shift amount of the central axis of the wavelength-combined beam 19 according to the measured drive current. Because a correlation exists between the input current and the wavelength shift amount $\Delta\lambda$, a table defining the correspondence between the input current and the wavelength shift amount $\Delta\lambda$ may be prepared in advance. The control device 50 can estimate the wavelength shift amount $\Delta\lambda$ from the input current with reference to this table.

The control device 50 determines the shift amount of the central axis of the wavelength-combined beam 19 based on the estimated wavelength shift amount Δλ. The control device 50 can determine the shift amount of the central axis of the wavelength-combined beam 19 further based on pulse output conditions that define the pulse frequency, the pulse width, the pulse waveform, and the like of a pulse signal that is a control signal for the movable stage 41.

The control device 50 generates a control signal that defines a target movement position, a target movement speed, a target acceleration, and the like based on the determined shift amount, and transmits the control signal to the movable stage 41. The movable stage 41 moves the optical coupling unit 40 according to the control signal. For example, the shift amount is determined each time the input current changes, and a control signal generated based on the shift amount is transmitted to the movable stage 41. In this example, the movable stage moves in synchronization with a change in the input current.

FIG. 7 is a schematic view illustrating a first implementation example of an optical coupling unit 40A. In FIG. 7, the wavelength-combined beam 19 before the central axes of the laser beams are shifted is indicated by a solid line, and the wavelength-combined beam 19 after the shift is indicated by a dotted line.

The optical coupling unit 40A in the first implementation example includes a movable stage 41, a light converger 42 that converges the wavelength-combined beam 19, and an optical coupling portion 43 connected to an end face or a terminal end of the optical transmission fiber 60. The movable stage 41 supports the light converger 42 and the optical coupling portion 43. The movable stage 41 can move the light converger 42 and the optical coupling portion 43 in the X-axis direction. The light converger 42 in the example illustrated in FIG. 7 is a converging lens that converges the wavelength-combined beam 19. However, the light converger 42 may include two or more lenses. The light converger 42 may include an aspherical lens that converges the wavelength-combined beam 19. The movable stage 41 and the aspherical lens are combined, so that the coupling efficiency can be increased.

The optical coupling portion 43 includes an end cap and is fixed at a position where the wavelength-combined beam 19 exiting from the light converger 42 is incident, in other words, a position where the wavelength-combined beam 19 is converged. The wavelength-combined beam 19 is converged by the light converger 42 and enters the optical coupling portion 43.

In the examples illustrated in FIGS. 6 and 7, the traveling direction of the plurality of laser beams 10, the traveling direction of the plurality of collimated beams 11, and the traveling direction of the wavelength-combined beam 19 are parallel to the first direction. The wavelength-combined beam 19 is converged by the light converger 42 and enters the optical coupling portion 43. In this way, the wavelength-combined beam 19 exiting from the wavelength beam combining device 100 can be efficiently converged to the optical transmission fiber 60 by the optical coupling unit 40A. Moreover, the movable stage 41 supports the light converger 42 and the optical coupling portion 43 in a state in which the relative positional relationship between the light converger 42 and the optical coupling portion 43 is maintained. Accordingly, the optical coupling unit 40A is moved in the shift direction of the central axis of the wavelength-combined beam 19, while maintaining the positional relationship between the light converger 42 and the optical coupling portion 43, so that the wavelength-combined beam 19 can be efficiently converged by the light converger 42. As a result, a decrease in the coupling efficiency of the optical transmission fiber 60 can be suppressed.

As illustrated in FIG. 7, when the central axis of the wavelength-combined beam 19 is shifted by Δx in the negative X-axis direction according to the operating state of the laser light source 500, the control device 50 moves the movable stage 41 by the shift amount Δx in the same direction as the shift direction of the central axis of the laser beam. In this way, automatic control is performed to move the light converger 42 and the optical coupling portion 43 in conjunction with the shift of the central axis of the laser beam.

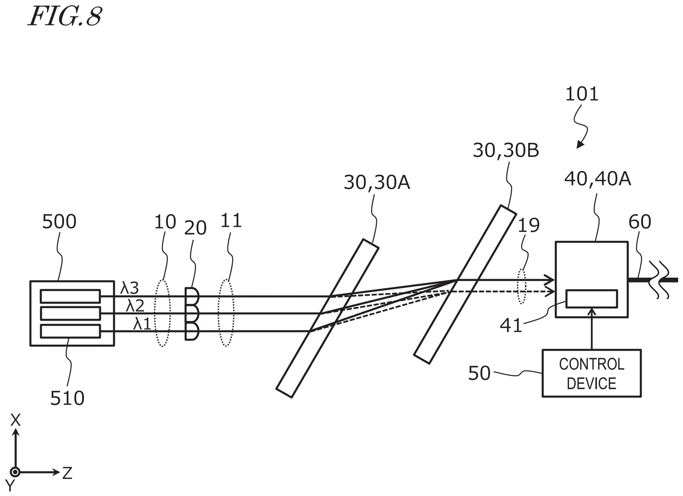

FIG. 8 is a plan view schematically illustrating another configuration of a wavelength beam combining device according to the first embodiment of the present disclosure as seen along the direction perpendicular to the XZ plane. A wavelength beam combining device 101 illustrated in FIG. 8 includes a pair of diffraction gratings 30 disposed in parallel. Both first and second diffraction gratings 30A and 30B are a transmissive diffraction grating, similarly to the wavelength beam combining device 100 illustrated in FIG. 6. However, in this example, transmitted light is used instead of reflected light. In this way, the transmitted light of the transmissive diffraction grating can also be used.

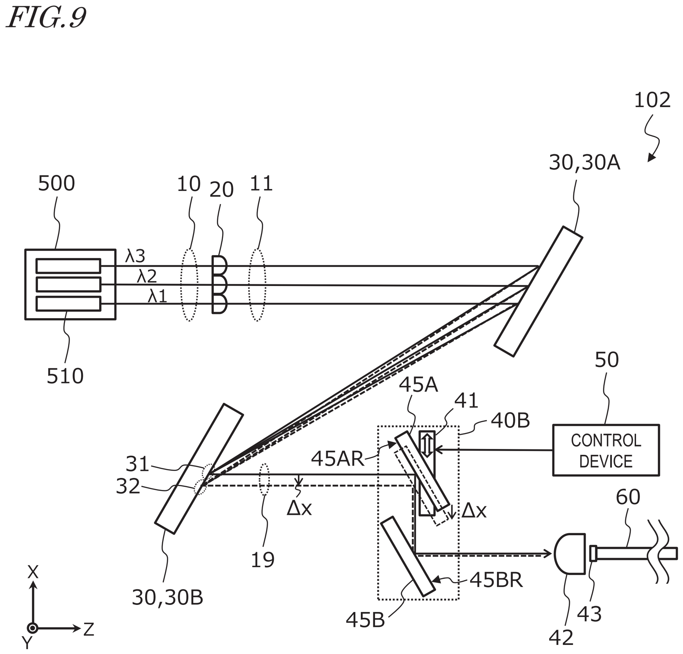

FIG. 9 is a schematic view illustrating a second implementation example of an optical coupling unit. An optical coupling unit 40B in the second implementation example includes a movable stage 41 that operates under the control of the control device 50, and a first mirror 45A and a second mirror 45B disposed in parallel to each other on an optical path between the second diffraction grating 30B and the optical transmission fiber 60. The first mirror 45A has a first reflective surface 45AR, and the second mirror 45B has a second reflective surface 45BR. The first reflective surface 45AR and the second reflective surface 45BR are perpendicular to a plane (XZ plane in the drawing) including the first direction and the second direction. The first reflective surface 45AR receives the wavelength-combined beam 19, and reflects the wavelength-combined beam 19 toward the second reflective surface 45BR. The second reflective surface 45BR reflects the wavelength-combined beam 19 reflected by the first reflective surface 45AR, and directs the wavelength-combined beam 19 toward the optical coupling portion 43 of the optical transmission fiber 60.

The movable stage 41 supports the first mirror 45A out of the first mirror 45A and the second mirror 45B, and moves the first mirror 45A in the second direction by a shift amount determined based on the operating state of the laser light source 500. Although FIG. 9 illustrates an example in which the first mirror 45A is supported and moved in the second direction, the same or similar effect is obtained by supporting the second mirror 45B and moving the second mirror 45B in the first direction.

A wavelength beam combining device 102 illustrated in FIG. 9 includes a light converger 42 that converges the wavelength-combined beam 19 reflected by the second reflective surface 45BR of the second mirror 45B. The optical coupling portion 43 includes an end cap and is fixed at a position where the wavelength-combined beam 19 emitted from the light converger 42 is incident. The wavelength-combined beam 19 is converged by the light converger 42 and enters the optical coupling portion 43.

In the example illustrated in FIG. 9, the central axis of the wavelength-combined beam 19 in a state in which no wavelength shift occurs is indicated by a solid line, and the central axis of the wavelength-combined beam 19 in a state in which a wavelength shift has occurred is indicated by a dotted line. When the center axis of the wavelength-combined beam 19 is shifted by $\Delta x$ in the negative X-axis direction according to the operating state of the laser light source 500, the movable stage 41 is moved by the shift amount $\Delta x$ in the same direction as the shift direction of the center axis of the laser beam, and the first mirror 45A is moved. In this way, one of the pair of mirrors disposed in parallel is supported by the movable stage, and the movable stage 41 is moved in the same direction as the shift direction of the central axis of the laser beam, so that an optical coupling unit can be implemented by a relatively simple optical system.

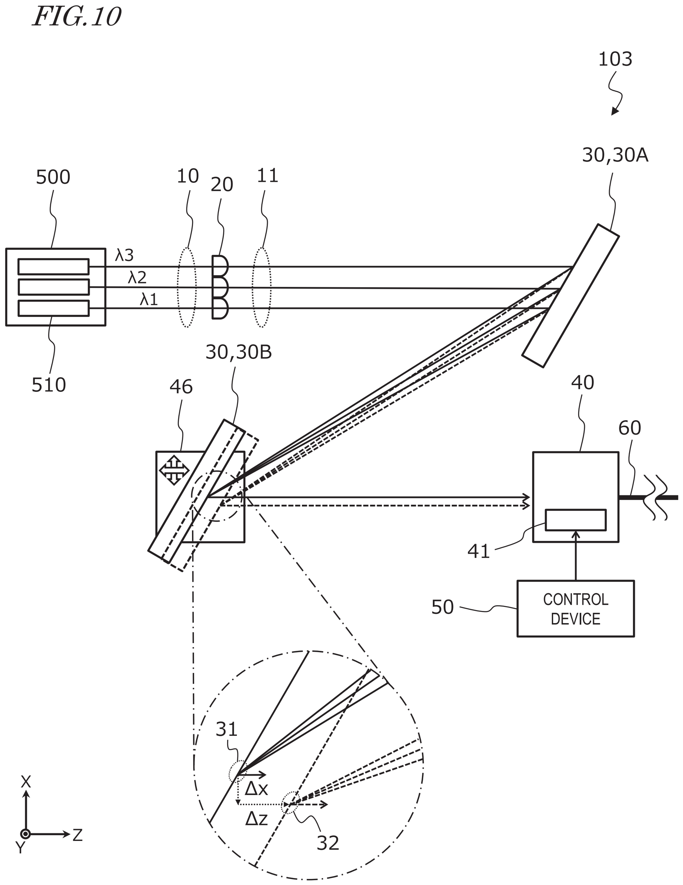

FIG. 10 is a plan view schematically illustrating still another configuration of a wavelength beam combining device according to the first embodiment of the present disclosure as seen along the direction perpendicular to the XZ plane. A wavelength beam combining device 103 illustrated in FIG. 10 may include a moving unit 46 that supports the second diffraction grating 30B and enables the second diffraction grating 30B to move in at least one of the first direction or the second direction. The moving unit 46 illustrated in FIG. 10 is a biaxial automatic stage that supports the second diffraction grating 30B to be movable in the X-axis and Z-axis directions. Accordingly, the second diffraction grating 30B can be moved on the XZ plane.

Compared to when the second diffraction grating 30B is moved in one of the X-axis direction or the Z-axis direction, the second diffraction grating 30B is moved in two axial directions, that is, the X-axis direction and the Z-axis direction, thereby having an advantage in suppressing an increase in the size of the second diffraction grating 30B. Therefore, the second diffraction grating 30B is preferably moved in two axial directions, that is, the X-axis direction and the Z-axis direction.

When the position of the second diffraction grating 30B is fixed, as described above, the diffraction angle at the first diffraction grating 30A changes due to the wavelength shift, and the spot on the second diffraction grating 30B on which the reflected diffracted light is incident moves by $\Delta x$ and $\Delta z$ in the X-axis direction and the Z-axis direction illustrated in FIG. 10, respectively. In this case, the second diffraction grating 30B is moved by the shift amount $\Delta x$ in the X-axis direction and by the shift amount $\Delta z$ in the Z-axis direction so as to follow the movement of the spot, so that a spot can be formed in a desired region on a surface of the second diffraction grating 30B on which the diffraction grooves are formed. In addition, vignetting of the laser beam at the second diffraction grating 30B can be suppressed.

2. Second Embodiment of Wavelength Beam Combining Device

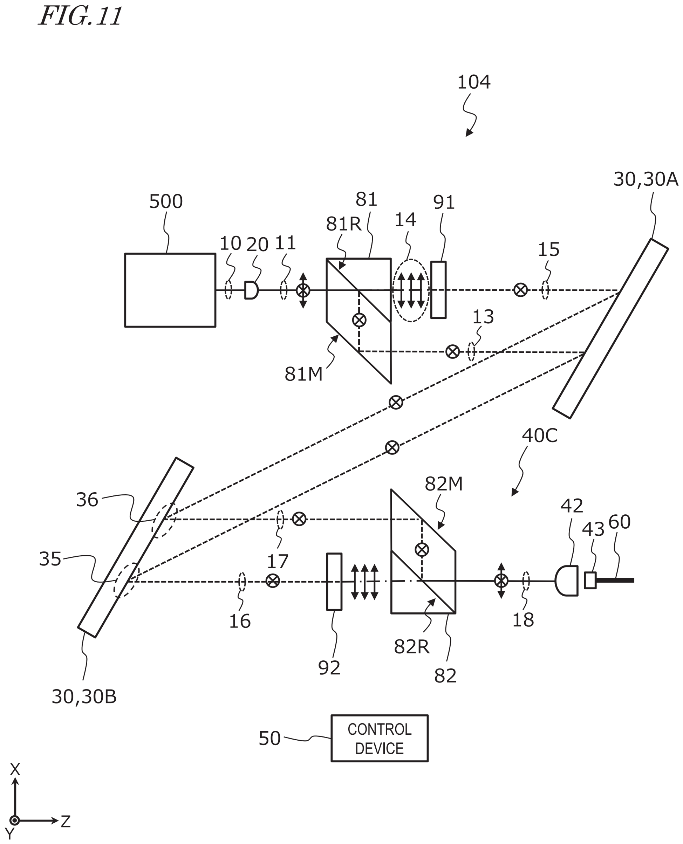

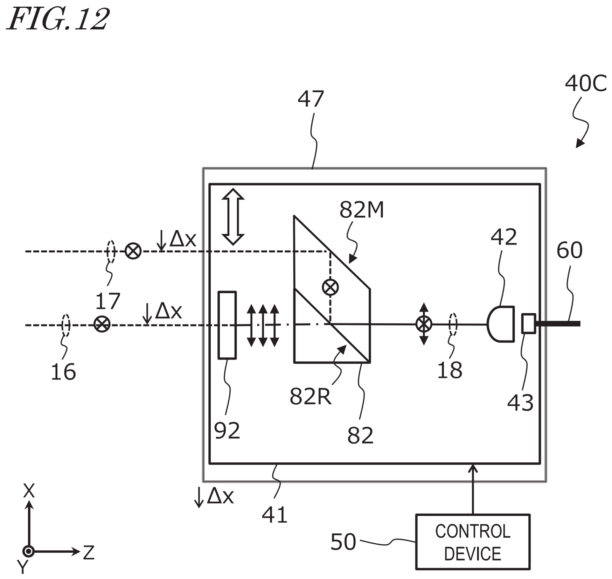

A wavelength beam combining device according to a second embodiment of the present disclosure is described with reference to FIGS. 11 and 12.

The wavelength beam combining device according to the second embodiment of the present disclosure further includes a polarization split and synthesis mechanism. Specifically, the wavelength beam combining device may further include a polarization beam splitter, a first polarization conversion element, a polarization beam combiner, and a second polarization conversion element. In such a wavelength beam combining device, a plurality of laser beams having mutually different peak wavelengths can be combined, and the output and power density of a wavelength-combined beam can be further increased.

FIG. 11 is a plan view schematically illustrating a configuration of the wavelength beam combining device according to the second embodiment of the present disclosure as seen along the direction perpendicular to the XZ plane. A wavelength beam combining device 104 further includes a polarization beam splitter 81, a first polarization conversion element 91, a polarization beam combiner 82, and a second polarization conversion element 92. The polarization beam splitter 81 is disposed on an optical path between the laser light source 500 and the first diffraction grating 30A. The first polarization conversion element 91 is disposed on an optical path between the polarization beam splitter 81 and the first diffraction grating 30A. The polarization beam combiner 82 is disposed on an optical path between the second diffraction grating 30B and the light converger 42. The second polarization conversion element 92 is disposed on an optical path between the second diffraction grating 30B and the polarization beam combiner 82.

The polarization beam splitter 81 splits each of the plurality of collimated beams 11 emitted from the collimator 20 into a plurality of first polarized beams 13 linearly polarized in a first polarization direction (Y-axis direction) and a plurality of second polarized beams 14 linearly polarized in a second polarization direction (direction on the XZ plane) orthogonal to the first polarization direction. In FIG. 11, for the sake of simplicity, the plurality of laser beams 10 emitted from the laser light source 500 and the plurality of collimated beams 11 emitted from the collimator 20 are collectively represented by one straight line. However, actually, the plurality of laser beams 10 travel side by side, and the plurality of collimated beams 11 travel side by side.

The polarization beam splitter 81 in the example illustrated in FIG. 11 has a reflective/transmissive surface 81R having a transmittance and a reflectance varying depending on the polarization state of the incident collimated beam 11. The reflective/transmissive surface 81R serves as a reflective surface for the first polarized beam 13 and serves as a transmissive surface for the second polarized beam 14. The reflective/transmissive surface 81R splits the incident collimated beam 11 into the first polarized beam 13 and the second polarized beam 14. The polarization beam splitter 81 further includes a mirror 81M that reflects, in the first direction, the first polarized beam 13 reflected in the second direction by the reflective/transmissive surface 81R. The first polarized beam 13 and the second polarized beam 14 are emitted in parallel from the polarization beam splitter 81. Light is an electromagnetic wave, and the electromagnetic field of the light is a transverse wave that oscillates in a direction perpendicular to the traveling direction of the light. The polarization state of the laser beam may vary depending on a gain medium, a resonator, an oscillation scheme, and the like of the laser light source 500. A laser beam in a specific polarization state at the stage of being emitted from the laser light source 500 may also be changed in its polarization state or be depolarized while passing through a transmission medium such as an optical fiber. The reflective/transmissive surface 81R of the polarization beam splitter 81 can selectively reflect polarized light components linearly polarized in a predetermined direction and transmit polarized light components linearly polarized in a direction orthogonal to the predetermined direction. The reflective/transmissive surface 81R is provided with, for example, a polarization-dependent dielectric multilayer film.

In general, when a light beam is incident on an object surface, a plane including a normal line of the object surface at an incident point and a traveling direction vector (wave number vector) of the light beam is defined as a "plane of incidence." Light linearly polarized in a direction perpendicular to the plane of incidence is called S-polarized light, and light linearly polarized in a direction parallel to the plane of incidence is called P-polarized light. In the example of FIG. 11, the reflective/transmissive surface 81R of the polarization beam splitter 81 is perpendicular to the XZ plane, and the normal line of the reflective/transmissive surface 81R is on a plane parallel to the XZ plane. The traveling direction of the collimated beam 11 is parallel to the XZ plane. Therefore, the "plane of incidence" for defining the polarization direction when the collimated beam 11 is incident on the reflective/transmissive surface 81R is parallel to the XZ plane. In the present disclosure, light linearly polarized in the first polarization direction being a direction perpendicular to the XZ plane is referred to as "S-polarized light." Light linearly polarized in a direction parallel to the XZ plane (second polarization direction orthogonal to the first polarization direction) is referred to as "P-polarized light." In the accompanying drawings, the "S-polarized light" is illustrated by a symbol surrounding a cross symbol with a small circle, and the "P-polarized light" is illustrated by a symbol with a double-headed arrow. Because the polarization direction of the "P-polarized light" is parallel to the XZ plane but perpendicular to the traveling direction of the laser beam, when the traveling direction of the laser beam is rotated by reflection or diffraction while being parallel to the XZ plane, the polarization direction of the "P-polarized light" is also rotated in a plane parallel to the XZ plane. Therefore, the "second polarization direction" in the present disclosure is defined as a direction perpendicular to the traveling direction of the laser beam and perpendicular to the first polarization direction.

In the example illustrated in FIG. 11, a transparent member having a parallelogram cross section is fixed to a transparent prism (or right-angle prism) having a triangular cross section via the reflective/transmissive surface 81R. The mirror 81M is formed on an inclined surface of the transparent member having a parallelogram cross section. When the condition of total reflection is applied, a mirror surface does not need to be formed. Instead of the transparent member having a parallelogram cross section, two right-angle prisms bonded to each other can be used. However, the transparent member having a parallelogram cross section is used, so that the right-angle prism does not need to be adjusted and reflection at an interface between the two right-angle prisms is further reduced.

The first polarization conversion element 91 converts the plurality of second polarized (P-polarized) beams 14 into a plurality of third polarized beams 15 linearly polarized in the first polarization (S polarization) direction. The plurality of second polarized beams 14 transmitted through the reflective/transmissive surface 81R of the polarization beam splitter 81 are converted into the third polarized beams 15 by the first polarization conversion element 91. The first polarization conversion element 91 is, for example, a half-wave plate (half-wave retardation plate). The half-wave plate has birefringence and changes a phase difference between two orthogonal components of an electromagnetic wave traveling in a thickness direction. A slow axis or a fast axis of the half-wave plate is disposed to form an angle of 45° relative to the polarization direction of the second polarized (P-polarized) beam 14, so that the half-wave plate can convert P-polarized light into S-polarized light.

In the example illustrated in FIG. 11, spots on the first diffraction grating 30A where the plurality of first polarized beams 13 enter are different from spots on the first diffraction grating 30A where the plurality of third polarized beams 15 enter. The first diffraction grating 30A diffracts the plurality of first polarized beams 13 in different directions according to wavelengths to cause the plurality of first polarized beams 13 to enter a first region 35 of the second diffraction grating 30B, and diffracts the plurality of third polarized beams 15 in different directions according to wavelengths to cause the plurality of third polarized beams 15 to enter a second region 36 different from the first region 35 of the second diffraction grating 30B.

The second diffraction grating 30B further diffracts the plurality of first polarized beams 13 entering the first region 35 to form a first wavelength-combined beam 16 in which the plurality of first polarized beams are coaxially superimposed, and further diffracts the plurality of third polarized beams 15 entering the second region 36 to form a second wavelength-combined beam 17 in which the plurality of third polarized beams 15 are coaxially superimposed.

In the second embodiment, when the wavelength shift described above occurs, the central axes of the first wavelength-combined beam 16 and the second wavelength-combined beam 17 are shifted in the second direction (that is, the X-axis direction) due to the occurrence of the wavelength shift. The shift direction of the central axis of the first wavelength-combined beam 16 is the same as the shift direction of the central axis of the second wavelength-combined beam 17. The shift amount of the central axis of the first wavelength-combined beam 16 is the same as the shift amount of the central axis of the second wavelength-combined beam 17. When the central axes of the first wavelength-combined beam 16 and the second wavelength-combined beam 17 are shifted according to the operating state of the laser light source 500, the control device 50 performs control to move the light converger 42, the optical coupling portion 43, the polarization beam combiner 82, and the second polarization conversion element 92 in the shift direction of the central axes of the wavelength-combined beams by a shift amount determined based on the operating state of the laser light source 500. The wavelength beam combining device 104 illustrated in FIG. 11 includes an optical coupling unit 40C according to a third implementation example.

FIG. 12 is a schematic view illustrating the third implementation example of an optical coupling unit. The optical coupling unit 40C includes a movable stage 41, a light converger 42, and an optical coupling portion 43, and further includes a polarization beam combiner 82 and a second polarization conversion element 92. The movable stage 41 in the example illustrated in FIG. 12 further supports the polarization beam combiner 82 and the second polarization conversion element 92, and moves the light converger 42, the optical coupling portion 43, the polarization beam combiner 82, and the second polarization conversion element 92 by a shift amount in the second direction.

The optical coupling unit 40C illustrated in FIG. 12 includes a mounting substrate 47 on which the light converger 42, the optical coupling portion 43, the polarization beam combiner 82, and the second polarization conversion element 92 are mounted. The movable stage 41 supports the mounting substrate 47, thereby indirectly supporting the light converger 42, the optical coupling portion 43, the polarization beam combiner 82, and the second polarization conversion element 92. In this way, the light converger 42, the optical coupling portion 43, the polarization beam combiner 82, and the second polarization conversion element 92 are mounted on the same substrate, so that the movement of the optical coupling unit 40C can be easily controlled. In addition, compared to when the polarization beam combiner 82 and the second polarization conversion element 92 are not moved by the movable stage 41, an increase in the size of the polarization beam combiner 82 and the second polarization conversion element 92 can be suppressed.

When the central axes of the first wavelength-combined beam 16 and the second wavelength-combined beam 17 are shifted by Δx in the negative X-axis direction according to the operating state of the laser light source 500, automatic control is implemented in which the light converger 42, the optical coupling portion 43, the polarization beam combiner 82, and the second polarization conversion element 92 are moved by moving the movable stage 41 by the shift amount Δx in the same direction as the shift direction of the central axes of the beams.

As described above, the optical coupling unit according to the third implementation example can move the light converger 42, the optical coupling portion 43, the polarization beam combiner 82, and the second polarization conversion element 92 in conjunction with one another by using the movable stage 41. These four optical elements are interlocked, so that vignetting of the laser beam by the polarization beam combiner 82 or the second polarization conversion element 92 can be suppressed. In addition, a uniaxial automatic stage can be used as the movable stage 41, so that control or alignment of the movable stage 41 can be facilitated.

Reference is again made to FIG. 11. The second polarization conversion element 92 is configured to change the polarization state of at least one of the first wavelength-combined beam 16 or the second wavelength-combined beam 17 so that the polarization directions of the first wavelength-combined beam 16 and the second wavelength-combined beam 17 are orthogonal to each other. Similarly to the first polarization conversion element 91, the second polarization conversion element 92 is, for example, a half-wave plate (half-wave retardation plate). In the example illustrated in FIG. 11, the second polarization conversion element 92 rotates the polarization direction of the first wavelength-combined beam 16 by 90°. The first wavelength-combined beam 16 transmitted through the second polarization conversion element 92 is linearly polarized in the second polarization direction. Unlike this example, the second polarization conversion element 92 may be placed at a position where the polarization direction of the second wavelength-combined beam 17 is rotated by 90°.

The polarization beam combiner 82 is configured to form a third wavelength-combined beam 18 in which the first wavelength-combined beam 16 and the second wavelength-combined beam 17 are coaxially superimposed, and cause the third wavelength-combined beam 18 to exit. In the example illustrated in FIG. 11, the polarization beam combiner 82 has the same structure as the polarization beam splitter 81. In general, a polarization beam splitter can also be used as a polarization beam combiner. However, the orientation is rotated by 180° around the Y axis. In the example illustrated in FIG. 11, the first wavelength-combined beam 16 transmitted through the second polarization conversion element 92 is P-polarized light, and the second wavelength-combined beam 17 is S-polarized light. The polarization beam combiner 82 includes a mirror 82M that reflects, in the second direction, the second wavelength-combined beam 17 traveling in the first direction, and a reflective/transmissive surface 82R that reflects the S-polarized light and transmits the P-polarized light. As a result, the polarization beam combiner 82 can allow to exit the third wavelength-combined beam 18 in which the first wavelength-combined beam (P-polarized light) 16 transmitted through the second polarization conversion element 92, and the second wavelength-combined beam (S-polarized light) 17 are coaxially superimposed.

The third wavelength-combined beam 18 is a laser beam obtained by wavelength combining of the plurality of laser beams 10 having different peak wavelengths. In this way, the wavelength beam combining device 104 can increase the output and power density of a wavelength-combined laser beam. As the number of laser beams 10 to be combined is increased, the output and power density of the third wavelength-combined beam 18 can be increased in proportion to the number of the laser beams, while maintaining the beam quality.

In the example illustrated in FIG. 11, the laser beams entering the pair of diffraction gratings 30 are the plurality of first polarized beams 13 of S-polarized light and the plurality of third polarized beams 15 of S-polarized light. In a case in which the diffraction grating has polarization dependency, when a non-polarized laser beam enters, the diffraction efficiency decreases depending on the polarization component. In the present embodiment, each of the pair of diffraction gratings 30 has diffraction grooves parallel to the first polarization direction (Y-axis direction). In the present embodiment, the diffraction grating 30 is used in which the diffraction efficiency to the S-polarized light is higher than the diffraction efficiency to the P-polarized light, so that the occurrence of optical loss in the diffraction grating can be suppressed.

In the wavelength beam combining device of the present embodiment, the diffraction grating is combined with the polarization split and synthesis mechanism, and thus the diffraction efficiency can be increased by using the diffraction grating suitable for the polarization state of incident light, and the output and power density can be further increased by coaxially combining diffracted light generated by the diffraction grating.

Japanese Patent Publication No. 2023-088438 and Japanese Patent Publication No. 2024-172262 disclose in more detail a wavelength beam combining device including a diffraction grating and a polarization split and synthesis mechanism.

3. Third Embodiment of Wavelength Beam Combining Device

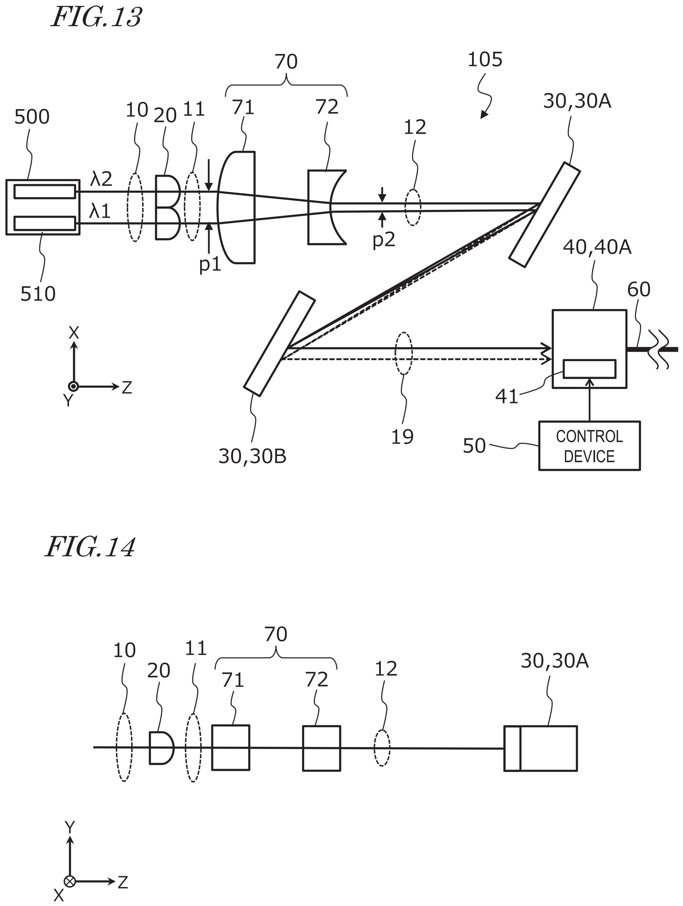

A wavelength beam combining device according to a third embodiment of the present disclosure is described with reference to FIGS. 13 to 19.

FIG. 13 is a plan view schematically illustrating a configuration of the wavelength beam combining device according to the third embodiment of the present disclosure as seen along the direction perpendicular to the XZ plane. In FIG. 13, a state in which a laser beam travels when no wavelength shift occurs is indicated by a solid line, and a state in which a laser beam travels when the wavelength shift has occurred is indicated by a dotted line. FIG. 14 is a plan view schematically illustrating a configuration of the wavelength beam combining device according to the third embodiment of the present disclosure as seen along a direction perpendicular to the YZ plane. However, FIG. 14 does not illustrate the second diffraction grating 30B, the optical coupling unit 40, the movable stage 41, or the control device 50 illustrated in FIG. 13.

A wavelength beam combining device 105 illustrated in FIG. 13 further includes an optical element 70 disposed on the optical path between the collimator 20 and the first diffraction grating 30A, and configured to reduce the distance between the beam central axes of the plurality of collimated beams 11, and cause the plurality of collimated beams 11 to exit. For the sake of simplicity, FIG. 13 illustrates a state in which the distance between the beam center axes of the two laser beams 10 having the peak wavelengths λ1 and λ2 is reduced to cause the laser beams 10 to exit.

The optical element 70 is configured to reduce the distance between the beam central axes of the plurality of collimated beams 11, and cause the collimated beams 11 to exit. A plurality of collimated beams 12 affected by the optical element 70 are incident on the first diffraction grating 30A. The optical element 70 may include at least one lens that condenses the plurality of collimated beams 11 on a first plane (XZ plane) including the first direction (Z-axis direction) and the second direction (X-axis direction). The lens constituting the optical element 70 is, for example, an axially symmetric lens such as a spherical lens or an aspherical lens, or a cylindrical lens. The material of the lens constituting the optical element 70 may be an optical glass such as synthetic silica or BK7. Because a plurality of high-power laser beams enter, the lens is preferably formed of synthetic silica.

The optical element 70 is, for example, a beam reducer. The optical element 70 in the present embodiment is a beam reducer. For example, a Keplerian beam reducer or a Galilean beam reducer can be used as the beam reducer. Alternatively, as the optical element 70, an anamorphic lens may be used instead of the beam reducer. The beam reducer in the present embodiment can reduce the beam diameter of each collimated beam 11, in addition to reduction in the distance between the beam central axes of the plurality of collimated beams 11.

In the examples illustrated in FIGS. 13 and 14, the optical element (beam reducer) 70 is of the Galilean type, but is not limited thereto. The optical element 70 includes two lenses 71 and 72, each of which condenses light on the XZ plane. Each of the two lenses 71 and 72 is a cylindrical lens, and has a function of condensing light on the XZ plane, but does not have a function of condensing light on the YZ plane. The two lenses 71 and 72 may be referred to as an incident-side lens 71 and an exit-side lens 72, respectively.

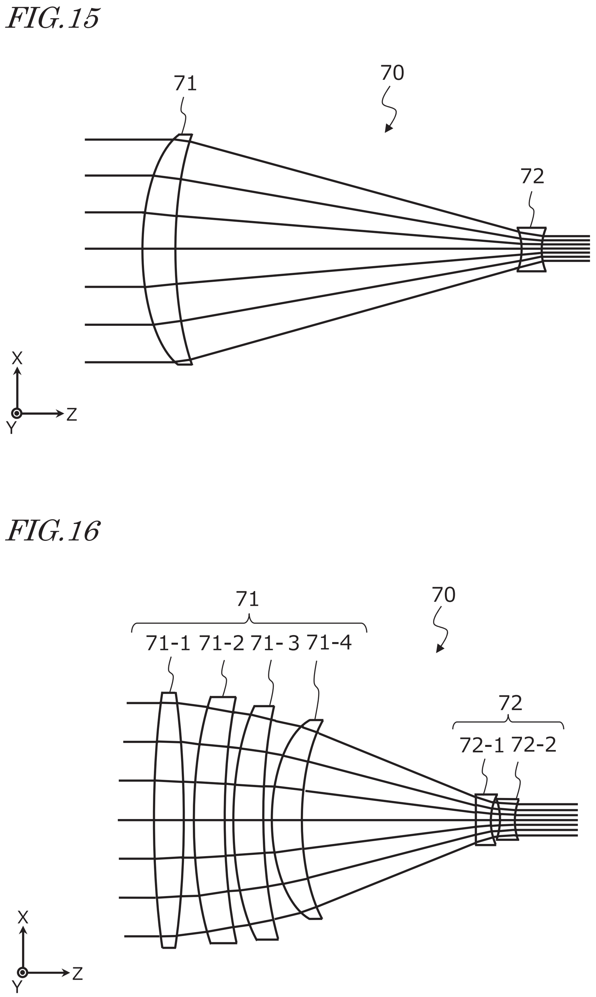

Each of FIGS. 15 and 16 is a view schematically illustrating a configuration example of a beam reducer having a Galilean lens configuration. Each of FIGS. 15 and 16 illustrates seven collimated beams with their central axes parallel to one another. The optical element 70 illustrated in FIG. 15 is a beam reducer including the two lenses 71 and 72. The incident-side lens 71 is an aspherical lens, and the exit-side lens 72 is a spherical lens. When an aspherical lens is used, the optical element 70 can be designed with a reduced number of lenses.

The optical element 70 illustrated in FIG. 16 is a beam reducer including a plurality of lens groups. Each of the plurality of lens groups is a spherical lens. The incident-side lens 71 includes four spherical lenses 71-1 to 71-4. The exit-side lens 72 includes two spherical lenses 72-1 and 72-2. When a spherical lens is used in this way, spherical aberration is likely to occur. However, the optical element 70 is formed of a plurality of lens groups, so that the spherical aberration can be reduced by gradually reducing an optical path. In this way, the optical element 70 may include a plurality of axially symmetric lenses.

Reference is again made to FIG. 13. The optical element 70 may include a lens with a positive focal distance and a lens with a negative focal distance. In the example illustrated in FIG. 13, the lens 71 of the optical element 70 is a cylindrical lens with a positive focal distance, and the lens 72 is a cylindrical lens with a negative focal distance. A lens with a negative focal distance is used, so that the distance between the two lenses can be reduced. As a result, the optical path length of the laser beam can be reduced.

The focal distance of the incident-side lens 71 illustrated in FIG. 13 is set as f1 and the focal distance of the exit-side lens 72 is set as f2. The optical element 70 that is a beam reducer has a magnification M for reducing an incident light pitch to 1/M. The magnification M of the beam reducer is determined by the ratio of the lens focal distances, and is given by Equation (1) below. Where p1 is a pitch of incident light entering the optical element 70 (incident-side lens 71), and p2 is a pitch of light exiting from the optical element 70 (exit-side lens 72), that is, a pitch of incident light entering the first diffraction grating 30A. The magnification M of the beam reducer may be, for example, in a range from 2 to 20.

$$M = f1/-f2 = p1/p2 \quad \text{Equation (1)}$$

For example, when f1 is 100 (mm) and f2 is -10 (mm), the magnification M becomes 10. In this case, when the incident light pitch p1 is 5 mm, the pitch p2 of the exiting light is 0.5 mm. In this way, using the optical element 70 makes it possible to reduce the pitch of the incident light entering the first diffraction grating 30A in accordance with the magnification of the beam reducer. This contributes to a reduction in an interval $\Delta\lambda$ between the peak wavelengths of laser beams. However, a residual divergence angle indicating a spread angle from parallel light is increased by the magnification, thereby preserving the beam quality.

The principle that the interval $\Delta\lambda$ of the peak wavelengths of the laser beams can be reduced by reducing the pitch of incident light to a diffraction grating, and the reason why the number of laser beams to be combined is limited by the pitch of the incident light entering the diffraction grating are described in detail in Japanese Patent Publication No. 2024-172262.

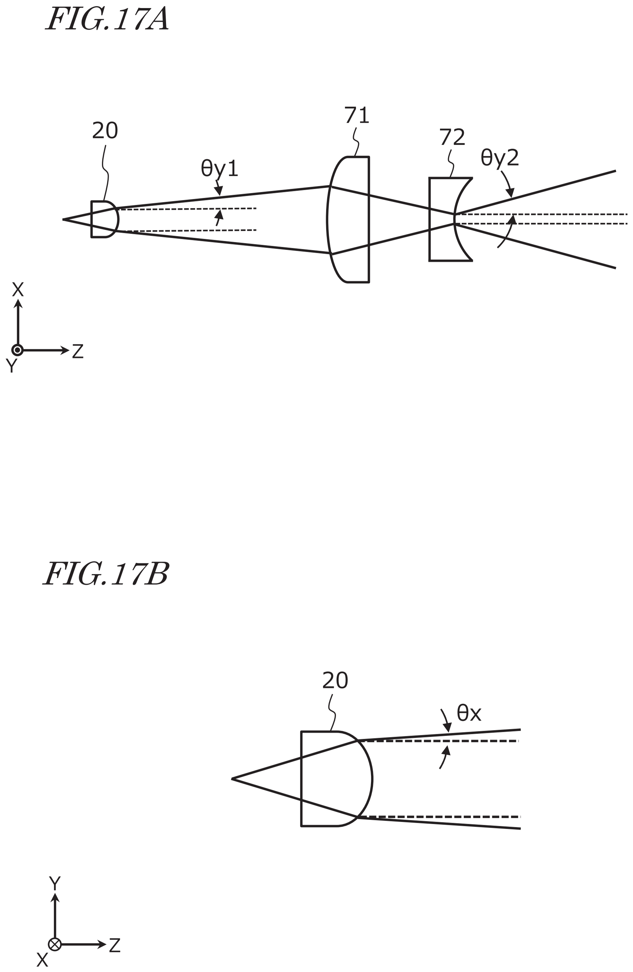

FIG. 17A is a schematic view for explaining the divergence angle of the laser beam on the XZ plane. FIG. 17B is a schematic view for explaining the divergence angle of the laser beam on the YZ plane. In FIG. 17A, a divergence angle $\theta y1$ of the collimated beam exiting from the collimator 20, and a divergence angle $\theta y2$ of the collimated beam transmitted through the incident-side lens 71 and exiting from the exit-side lens 72 satisfy the relationship of Equation (2) below.

$$\theta y2 = M \cdot \theta y1 \quad \text{Equation (2)}$$

In this way, the distance between the beam central axes of the plurality of collimated beams is reduced by the action of the optical element 70, and the residual divergence angle is increased. However, at least one cylindrical lens that does not have a function of condensing light on the YZ plane, but condenses light on the XZ plane is adopted, so that the distance between the beam central axes of the plurality of collimated beams 11 in the second direction (X-axis direction) can be reduced as illustrated in FIG. 13, while maintaining a residual divergence angle $\theta x$ in a third direction (Y-axis direction) orthogonal to the first and second directions as illustrated in FIG. 17B. In the present embodiment, because an incident light pitch does not need to be reduced in the Y-axis direction, a beam reducer in the Y-axis direction is not necessary.

In the example illustrated in FIG. 13, the traveling direction of the plurality of laser beams 10, the traveling direction of the plurality of collimated beams 11 and 12, and the traveling direction of the wavelength-combined beam 19 are parallel to the first direction. The wavelength-combined beam 19 is converged by the optical coupling unit 40 and enters the optical transmission fiber 60. In this way, for example, the optical coupling unit 40A according to the first implementation example can efficiently couple the wavelength-combined beam 19 emitted from the wavelength beam combining device 105 to the optical transmission fiber 60.

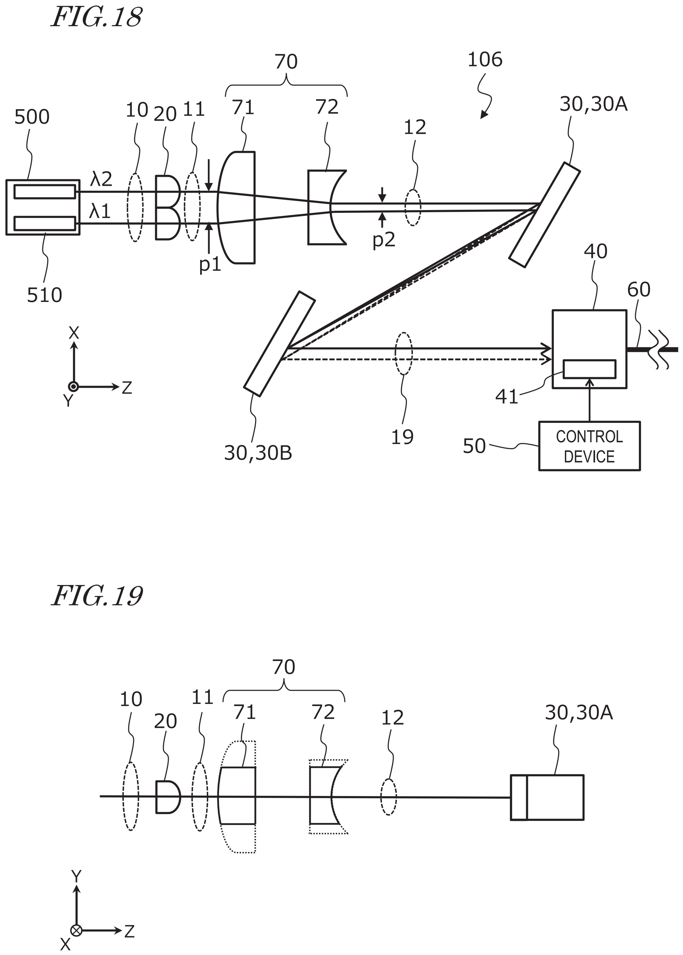

FIG. 18 is a plan view schematically illustrating another configuration of the wavelength beam combining device according to the third embodiment of the present disclosure as seen along the direction perpendicular to the XZ plane. In FIG. 18, a state in which a laser beam travels when no wavelength shift occurs is indicated by a solid line, and a state in which a laser beam travels when the wavelength shift has occurred is indicated by a dotted line. FIG. 19 is a plan view schematically illustrating another configuration of the wavelength beam combining device according to the third embodiment of the present disclosure as seen along the direction perpendicular to the YZ plane.

In the examples illustrated in FIGS. 18 and 19, each of the two lenses 71 and 72 is an axially symmetric lens. However, as illustrated in FIG. 19, each of the two lenses 71 and 72 is cut at the Y-axis-direction top and bottom thereof to leave a central region through which the laser beam passes. In FIG. 19, for reference, an outer shape of the lens before cutting the top and bottom of the lens is indicated by a dotted line. In this example, the size of each of the two lenses 71 and 72 in the X-axis direction is larger than the size thereof in the Y-axis direction. Such a lens structure is adopted, so that a reduction in lens cost, a reduction in lens processing time, and a reduction in the weight of the optical element 70 are expected. The lens structure can contribute to space saving in the internal space of a wavelength beam combining device 106 and size reduction in the wavelength beam combining device 106. The two lenses 71 and 72 may be formed by injection molding or glass molding without the cutting processing.

When wavelength beam combining is performed, the distance between the beam central axes of the plurality of collimated beams 11 is reduced by the action of the optical element 70. Thus, the pitch of light incident on the first diffraction grating 30A can be reduced and the interval $\Delta\lambda$ between the peak wavelengths of the laser beams can be reduced. Thus, the number of wavelengths to be subjected to wavelength multiplexing can be increased, and as a result, the output of the wavelength beam combining device can be increased. In this way, the wavelength beam combining device 105 or 106 according to the present embodiment can further increase the output and power density of a wavelength-combined laser beam.

In the wavelength beam combining device 104 illustrated in FIG. 11, the optical element 70 may be disposed on an optical path between the collimator 20 and the polarization beam splitter 81. In the wavelength beam combining device having such a configuration, the output and power density can be further increased by combining the optical element that reduces the distance between the beam central axes, the diffraction grating, and the polarization split and synthesis mechanism.

<4. Fourth Embodiment of the Wavelength Beam Combining Device>

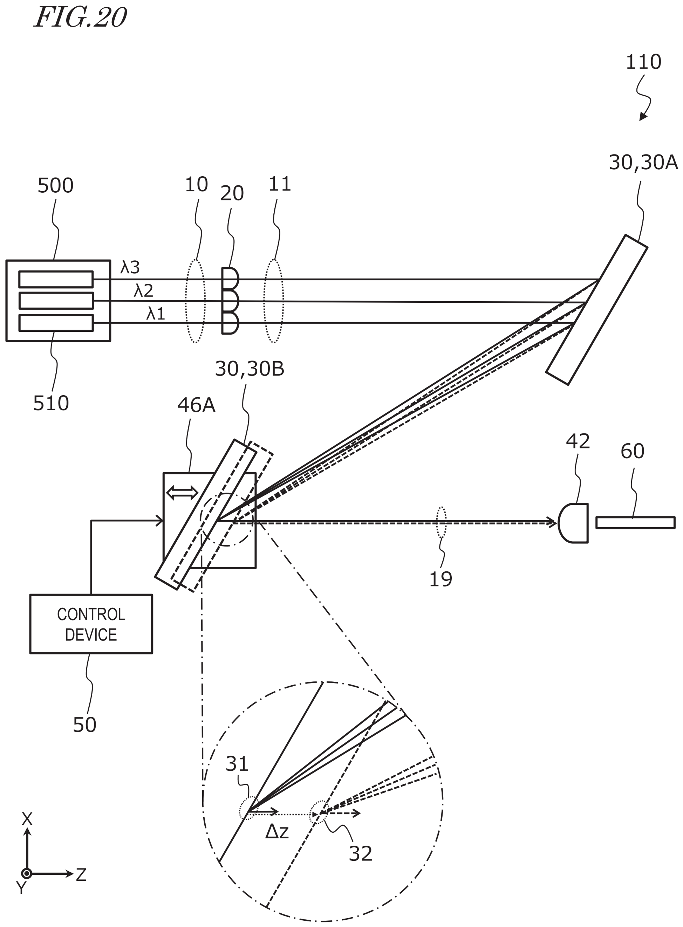

Referring to FIG. 20, a wavelength beam combining device according to a fourth embodiment of the present disclosure will be described.

FIG. 20 is a plan view schematically showing the configuration of the wavelength beam combining device according to the fourth embodiment of the present disclosure, as seen along a direction perpendicular to the XZ plane. The wavelength beam combining device 110 illustrated in FIG. 20 includes a moving unit 46A that supports the second diffraction grating 30B and enables the second diffraction grating 30B to move at least in the first direction, but does not include the above-described optical coupling unit configured to be movable in the second direction. The moving unit 46A illustrated in FIG. 20 is a single-axis automatic stage that supports the second diffraction grating 30B and enables the second diffraction grating 30B to move in the Z-axis direction, which is the first direction. However, like the moving unit 46 shown in FIG. 10, the moving unit 46A may be a two-axis automatic stage that supports the second diffraction grating 30B and enables the second diffraction grating 30B to move in both the X-axis and Z-axis directions.

The moving unit 46A may be configured to move the second diffraction grating 30B at least in the first direction in response to a signal defining the shift amount determined based on the operating state of the laser light source 500. The control device 50 in the example shown in FIG. 20 can be configured or programed so as to be electrically connected to the moving unit 46A, determine the shift amount based on the operating state of the laser light source 500, and transmit a signal defining the shift amount to the moving unit 46A.

When the position of the second diffraction grating 30B is fixed, as described above, the diffraction angle at the first diffraction grating 30A changes due to wavelength shift, and the spot on the second diffraction grating 30B where the reflected diffracted light is incident moves. In this case, by moving the second diffraction grating 30B by the shift amount Δz in the Z-axis direction as shown in FIG. 20, it is possible to align the central axis (solid line shown in FIG. 20) of the wavelength-combined beam 19 progressing at the design wavelength with the central axis (dotted line shown in FIG. 20) of the wavelength-combined beam 19 subjected to a wavelength shift, while forming the spot on a desired region of the surface of the second diffraction grating 30B where the diffraction grooves are formed.

The shift amount Δz that specifies the movement in the Z-axis direction can be predicted from the driving state of the laser light source 500. Therefore, the control device 50 can determine the shift amount Δz based on the driving state of the laser light source 500. The control device 50 transmits a signal defining the determined shift amount Δz to the moving unit 46A, thereby moving the second diffraction grating 30B by the shift amount Δz in the Z-axis direction. This can suppress the decrease in coupling efficiency of the optical transmission fiber 60. In this manner, even when the moving unit 46A is moved in the Z-axis direction, an effect equivalent to the case of moving the optical coupling unit in the X-axis direction can be obtained in suppressing the decrease in coupling efficiency.

The present inventor has verified the suppression effect on the decrease in coupling efficiency of the optical transmission fiber in both cases where the optical coupling unit is moved in the second direction (i.e., X-axis direction) and where the moving unit is moved in the first direction (i.e., Z-axis direction), using optical output [W] and beam combining efficiency [%] as indicators. Here, the optical output is defined by the optical power ($Pf$ [W]) output from the optical transmission fiber. The beam combining efficiency is defined by the ratio ($Pf/P0$) of the optical power ($Pf$ [W]) output from the optical transmission fiber to the optical power ($P0$ [W]) output from the laser light source. That is, the beam combining efficiency is the overall efficiency of the wavelength beam combining device obtained by multiplying the transmittance of the optical elements, diffraction efficiency of the diffraction grating, coupling efficiency to the optical transmission fiber, and transmission efficiency of the optical transmission fiber. The optical power ($P0$ [W]) output from the laser light source and the optical power ($Pf$ [W]) output from the optical transmission fiber were measured using the "Fan-Cooled Thermal Sensor (FL500A-LP1)" from OPHIR JAPAN LTD. As the laser light source, DBR-LDs with different wavelengths were used.

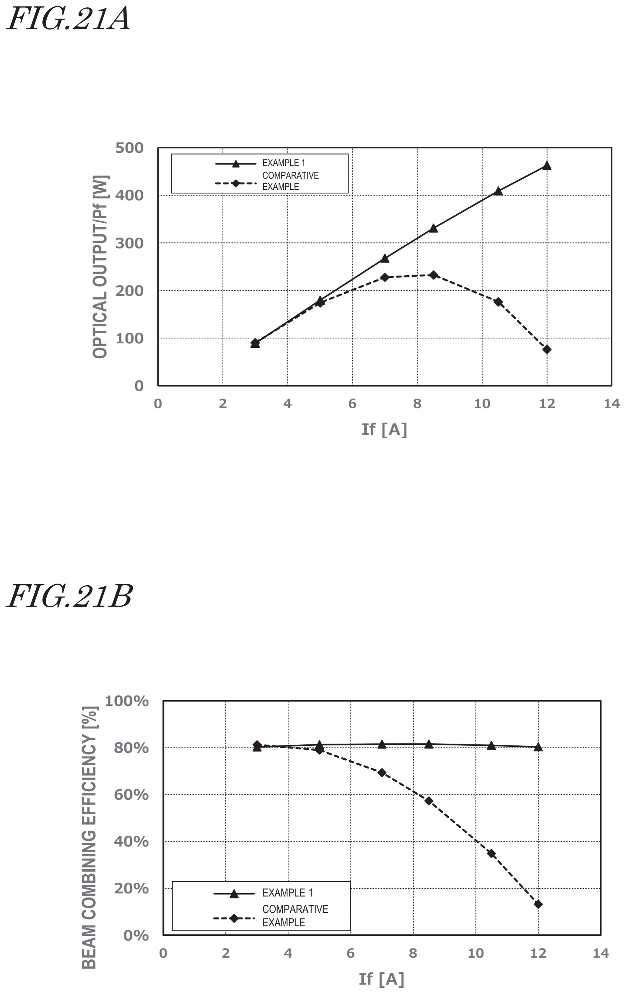

FIG. 21A is a graph showing measurement results of optical output when the optical coupling unit is moved in the second direction. FIG. 21B is a graph showing measurement results of beam combining efficiency when the optical coupling unit is moved in the second direction. In the graph of FIG. 21A, the vertical axis indicates the optical output [W], and the horizontal axis indicates the drive current [A] of the laser light source. In the graph of FIG. 21B, the vertical axis indicates the beam combining efficiency [%], and the horizontal axis indicates the drive current [A] of the laser light source. FIG. 21A shows the measured results of optical output when the optical coupling unit is moved in the second direction, and the calculated results of optical output when no countermeasure for wavelength shift is taken, as Example 1 and Comparative Example, respectively. FIG. 21B shows the measured results of beam combining efficiency when the optical coupling unit is moved in the second direction, and the calculated results of beam combining efficiency when no countermeasure for wavelength shift is taken, as Example 1 and Comparative Example, respectively.

In Example 1, the optical output [W] is the measured result of optical output [W] when three laser beams respectively having wavelengths of 457, 459, and 461 [nm] are wavelength beam combined., and the beam combining efficiency [%] is the measured result of beam combining efficiency [%] when these three laser beams are wavelength beam combined. In contrast, in the Comparative Example, the optical output [W] is the calculated result of optical output [W] estimated by theoretical calculation based on the actually measured wavelength shift amount, and the beam combining efficiency [%] is the calculated result of beam combining efficiency [%] estimated by theoretical calculation based on the actually measured wavelength shift amount.

In the graph of optical output shown in FIG. 21A, in the Comparative Example, the optical output decreases as the drive current of the laser light source increases, while in Example 1, the optical output increases proportionally with the increase in drive current. In the graph of beam combining efficiency shown in FIG. 21B, in the Comparative Example, the beam combining efficiency decreases as the drive current of the laser light source increases, while in Example 1, the beam combining efficiency remains almost constant even as the drive current increases.

Thus, it was confirmed that moving the optical coupling unit in the second direction as a countermeasure for wavelength shift can suppress the decrease in coupling efficiency of the optical transmission fiber.

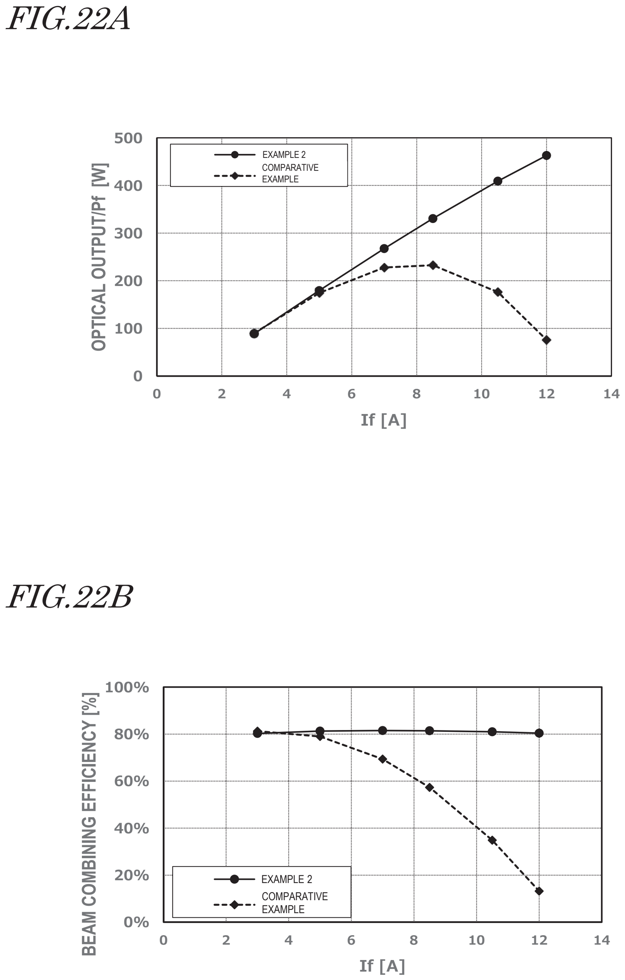

FIG. 22A is a graph showing measurement results of optical output when the moving unit is moved in the first direction. FIG. 22B is a graph showing measurement results of beam combining efficiency when the moving unit is moved in the first direction. In the graph of FIG. 22A, the vertical axis indicates the optical output [W], and the horizontal axis indicates the drive current [A] of the laser light source. In the graph of FIG. 22B, the vertical axis indicates the beam combining efficiency [%], and the horizontal axis indicates the drive current [A] of the laser light source. FIG. 22A shows the measured results of optical output when the moving unit is moved in the first direction, and the calculated results of optical output when no countermeasure for wavelength shift is taken, as Example 2 and Comparative Example, respectively. FIG. 22B shows the measured results of beam combining efficiency when the moving unit is moved in the first direction, and the calculated results of beam combining efficiency when no countermeasure for wavelength shift is taken, as Example 2 and Comparative Example, respectively.

In Example 2, the optical output [W], as in Example 1 in FIG. 21A, is the measured result of optical output [W] when three laser beams of wavelengths 457, 459, and 461 [nm] are wavelength beam combined, and the beam combining efficiency [%], as in Example 1 in FIG. 21B, is the measured result of beam combining efficiency [%] when these three laser beams are wavelength beam combined. In contrast, in the Comparative Example, the optical output [W], as in the Comparative Example in FIG. 21A, is the calculated result of optical output [W] estimated by theoretical calculation based on the actually measured wavelength shift amount, and the beam combining efficiency [%], as in the Comparative Example in FIG. 21B, is the calculated result of beam combining efficiency [%] estimated by theoretical calculation based on the actually measured wavelength shift amount.

In the graph of optical output shown in FIG. 22A, in the Comparative Example, the optical output decreases as the drive current of the laser light source increases, while in Example 2, the optical output increases proportionally with the increase in drive current. In the graph of beam combining efficiency shown in FIG. 22B, in the Comparative Example, the beam combining efficiency decreases as the drive current of the laser light source increases, while in Example 2, the beam combining efficiency remains almost constant even as the drive current increases.

Thus, it was confirmed that moving the moving unit in the first direction as a countermeasure for wavelength shift can suppress the decrease in coupling efficiency of the optical transmission fiber. Furthermore, based on the measurement results of Example 1 and Example 2, it was confirmed that both moving the optical coupling unit in the second direction and moving the moving unit in the first direction as countermeasures for wavelength shift can achieve substantially equivalent suppression effects on the decrease in coupling efficiency of the optical transmission fiber. In other words, it was confirmed that both moving the optical coupling unit and moving the moving unit are effective as countermeasures for wavelength shift.

5. Embodiment of Direct Diode Laser Device

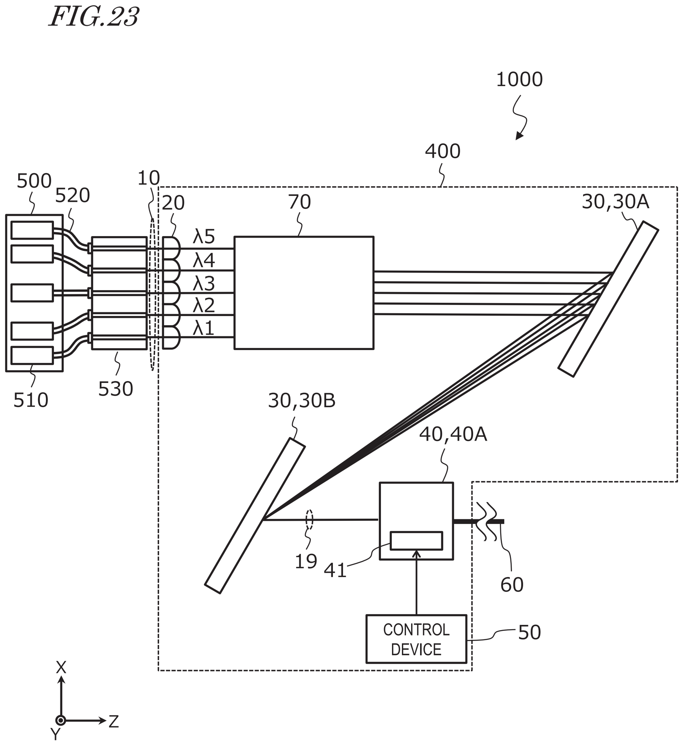

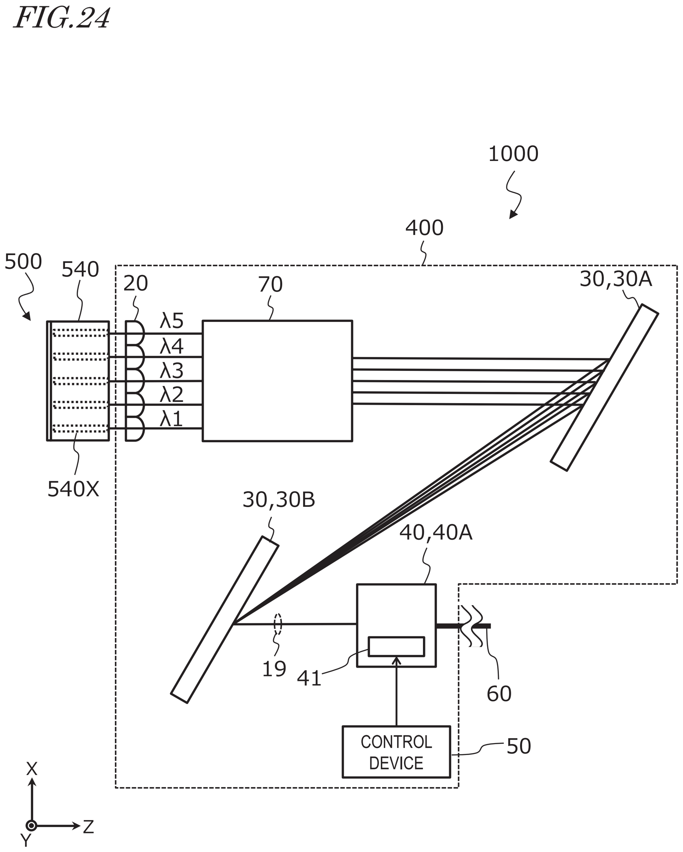

Embodiments of a direct diode laser device according to the present disclosure are described below with reference to FIGS. 23 and 24.

FIG. 23 is a plan view schematically illustrating a configuration of the direct diode laser device according to the embodiment of the present disclosure as seen along the direction perpendicular to the XZ plane. A direct diode laser device 1000 in the present embodiment includes a wavelength beam combining device 400, a laser light source 500 including a plurality of semiconductor laser devices 510 that emit beams of laser light having mutually different peak wavelengths, and an optical fiber array 530 configured to form laser beams 10 to be incident on collimators 20 of the wavelength beam combining device 400 from the beams of laser light emitted from the plurality of semiconductor laser devices 510. In the example illustrated in FIG. 23, beams of laser light having peak wavelengths of $\lambda1, \lambda2, \lambda3, \lambda4,$ and $\lambda5$ are emitted from the plurality of semiconductor laser devices 510. The laser light emitted from each semiconductor laser device 510 is optically coupled to a corresponding optical fiber 520 of the optical fiber array 530. Even though the laser light emitted from each semiconductor laser device 510 is linearly polarized light, when the optical fiber 520 is not a polarization maintaining fiber, the polarization state of the laser light changes in the process of passing through the optical fiber 520. Therefore, each of the plurality of laser beams 10 formed by the optical fiber array 530 in the present embodiment is non-polarized light.

Using the optical fiber array 530 makes it possible to align the optical fibers 520, and easily adjust the exiting angle of the laser beam 10. As a result, the plurality of laser beams 10 can easily exit in parallel from the optical fiber array 530 with high accuracy, for example. The optical fiber array 530 can also enable that an optical fiber extending from the laser light source 500 can be fused and connected to the optical fiber 520 of the optical fiber array 530.

FIG. 23 illustrates the direct diode laser device 1000 including the wavelength beam combining device 400 having the structure illustrated in FIG. 18. However, the direct diode laser device according to the embodiment of the present disclosure is not limited to the example illustrated in FIG. 23, and may include the various embodiments described above or modified examples of the embodiments. The plurality of laser beams 10 having mutually different peak wavelengths and exiting from the optical fiber array 530 in parallel to the first direction enter the collimators 20 of the wavelength beam combining device 400 in parallel to one another.

In the present embodiment, the optical elements such as the diffraction grating and the polarization conversion element included in the wavelength beam combining device are all plate-type. When the peak wavelength of the laser beam is included in a blue wavelength range, these optical elements may be formed of a material that is less likely to absorb light in the blue wavelength range, for example, synthetic silica. Thinning these optical elements and integrating the thinned optical elements in a predetermined space not only contributes to size reduction in the device but also facilitates adjustment of the temperature of the plurality of optical elements as a whole.

The wavelength-combined beam 19 is coupled to the optical transmission fiber 60 through the optical coupling unit 40. Examples of the optical transmission fiber 60 suitable for high-power optical transmission in the blue wavelength range include optical fibers having a "high OH-pure silica" core with a high OH group content, coreless fibers, and photonic crystal fibers.

FIG. 24 is a plan view schematically illustrating another configuration of the direct diode laser device according to the embodiment of the present disclosure as seen along the direction perpendicular to the XZ plane. A direct diode laser device 1000 illustrated in FIG. 24 includes a semiconductor laser element 540 as a laser light source 500. The semiconductor laser element 540 is a single light source whose wavelength is controlled. In the example illustrated in FIG. 24, the semiconductor laser element 540 is a laser bar having five laser oscillation regions 540X. Each of the five laser oscillation regions 540X is a distributed feedback LD or a distributed Bragg reflector LD. The five laser oscillation regions 540X perform laser oscillation at peak wavelengths of $\lambda 1$, $\lambda 2$, $\lambda 3$, $\lambda 4$, and $\lambda 5$, and emit beams of laser light having the peak wavelengths of $\lambda 1$, $\lambda 2$, $\lambda 3$, $\lambda 4$, and $\lambda 5$ individually. The number of laser oscillation regions 540X included in one laser bar is not limited to five, and may be two, three, or four, or may be six or more, for example, ten or more. The semiconductor laser element 540 may have a plurality of ridges or a plurality of stripe electrodes defining a plurality of the laser oscillation regions 540X. The semiconductor laser element 540 need not be a single laser bar, and may be a collection of a plurality of laser bars.

In the direct diode laser device of the present embodiment, the output and power density can be increased by coaxially combining diffracted light generated by a diffraction grating. In particular, the wavelength beam combining device according to the second embodiment is used, and thus, even though the polarization state of laser light emitted from a plurality of semiconductor laser devices or semiconductor laser elements is non-polarized by an optical fiber array device, the laser light is converted into linearly polarized light by a polarization beam splitter, so that diffraction efficiency can be increased by using a diffraction grating suitable for each polarization state. Reflected diffracted light generated by such a diffraction grating is coaxially combined, and thus the output and power density can be increased.

5. Embodiment of Laser Processing Machine

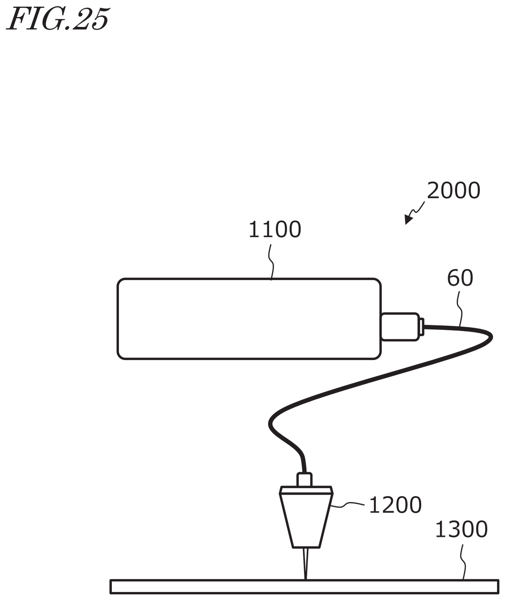

An embodiment of a laser processing machine 2000 according to the present disclosure is described below with reference to FIG. 25. FIG. 25 is a view illustrating a configuration example of a processing machine according to an embodiment of the present disclosure.

The illustrated laser processing machine 2000 includes a light source device 1100 and a processing head 1200 connected to an optical transmission fiber 60 extending from the light source device 1100. The processing head 1200 irradiates an object 1300 with a wavelength-combined beam emitted from the optical transmission fiber 60. In the illustrated example, the number of light source devices 1100 is one. The processing head 1200 may be connected to a plurality of light source devices 1100 via the optical transmission fiber 60.

The light source device 1100 is a direct diode laser device including a wavelength beam combining device having the configuration described above and a plurality of semiconductor laser devices or semiconductor laser elements that emit a plurality of laser beams having mutually different peak wavelengths. The wavelength beam combining device included in the light source device 1100 may be any of the various embodiments described above and modified examples of the embodiments. The number of semiconductor laser devices mounted on the light source device 1100 is not particularly limited, and is determined in accordance with required light output or irradiance. The wavelength of laser light emitted from the semiconductor laser device may also be selected in accordance with a material to be processed.

According to the present embodiment, because a high-power laser beam is generated by wavelength beam combining and is efficiently coupled to an optical fiber, a high-power density laser beam having good beam quality can be obtained with high energy conversion efficiency.

Laser beams emitted from the processing head 1200 may include laser beams other than laser beams emitted from the semiconductor laser device or the semiconductor laser element and combined. For example, although the peak wavelengths of the laser beams emitted from the semiconductor laser device and wavelength-combined are included in a range from 430 nm to 480 nm, laser beams having peak wavelengths in the near infrared range may be superimposed, for example. Depending on a material to be processed, a laser beam having a wavelength at which the absorption rate of the material is high can be superimposed as appropriate.

A wavelength beam combining device, a direct diode laser device, and a laser processing machine of the present disclosure can be widely used in applications requiring high-output and high-power density laser light with high beam quality, such as cutting, drilling, local heat treatment, surface treatment of various materials, welding of metal, and 3D printing. Reference Character List

20 Collimator, 30 Diffraction grating, 30A First diffraction grating, 30B Second diffraction grating, 40, 40A, 40B, 40C Optical coupling unit, 41 Movable stage, 42 Light converger, 43 Optical coupling portion, 45A, 45B First mirror, second mirror, 46 Moving unit, 47 Mounting substrate, 50 Control device, 60 Optical transmission fiber, 70 Optical element, 71, 72 Lens, 81 Polarization beam splitter, 82 Polarization beam combiner, 91 First polarization conversion element, 92 Second polarization conversion element, 100 to 106, 400 Wavelength beam combining device, 500 Laser light source, 510 Semiconductor laser device, 520 Optical fiber, 530 Optical fiber array, 540 Semiconductor laser element, 1000 Direct diode laser device, 1100 Light source device, 1200 Processing head, 1300 Object, 2000 Laser processing machine

**Claims**

1. A wavelength beam combining device comprising:

   a plurality of laser light sources configured to emit a plurality of laser beams in a first direction, the plurality of laser beams having mutually different peak wavelengths and having central axes arranged in a second direction intersecting the first direction;
   a first diffraction grating disposed at a position where the plurality of laser beams are received, the first diffraction grating being configured to diffract the plurality of laser beams in different directions according to wavelengths of the laser beams to cause the diffracted laser beams to enter the second diffraction grating;
   a second diffraction grating to diffract the plurality of laser beams diffracted by the first diffraction grating to form a wavelength-combined beam, and to direct the wavelength-combined beam in the first direction; and
   either an optical coupling unit configured to couple the wavelength-combined beam to an optical transmission fiber and to be movable in the second direction, or a moving unit supporting the second diffraction grating to enable the second diffraction grating to move at least in the first direction.

2. The wavelength beam combining device according to claim 1, comprising the optical coupling unit, wherein:
   the optical coupling unit comprises a movable stage configured to move the optical coupling unit by a shift amount in the second direction, in response to a signal defining the shift amount determined based on an operating state of the laser light source.

3. The wavelength beam combining device according to claim 2, wherein:
   the optical coupling unit comprises:

   a light converger configured to converge the wavelength-combined beam, and
   an optical coupling portion connected to an end face of the optical transmission fiber, and fixed at a position where the wavelength-combined beam exiting from the light converger is incident; and
   coupling portion.

4. The wavelength beam combining device according to claim 3, further comprising:

   a polarization beam splitter disposed between the laser light source and the first diffraction grating; and
   a first polarization conversion element disposed between the polarization beam splitter and the first diffraction grating; wherein:

   the optical coupling unit comprises:

   a polarization beam combiner disposed between the second diffraction grating and the light converger, and
   a second polarization conversion element disposed between the second diffraction grating and the polarization beam combiner; and

   the movable stage supports the polarization beam combiner and the second polarization conversion element, and is configured to move the light converger, the optical coupling portion, the polarization beam combiner, and the second polarization conversion element in the second direction by the shift amount.

5. The wavelength beam combining device according to claim 4, wherein:

   the optical coupling unit comprises a mounting substrate on which the light converger, the optical coupling portion, the polarization beam combiner, and the second polarization conversion element are mounted; and
   the movable stage supports the mounting substrate.

6. The wavelength beam combining device according to claim 1, comprising the optical coupling unit, wherein:

   the optical coupling unit comprises a first mirror and a second mirror disposed in parallel to each other between the second diffraction grating and the optical transmission fiber;
   the first mirror has a first reflective surface, and the second mirror has a second reflective surface, the first reflective surface and the second reflective surface being perpendicular to a plane defined by the first direction and the second direction; and
   the first reflective surface is configured to receive the wavelength-combined beam and to reflect the wavelength-combined beam toward the second reflective surface, and the second reflective surface is configured to reflect the wavelength-combined beam reflected by the first reflective surface and to direct the wavelength-combined beam toward the optical transmission fiber.

7. The wavelength beam combining device according to claim 6, wherein the optical coupling unit comprises a movable stage supporting the first mirror and configured to move the first mirror in the second direction by a shift amount determined based on an operating state of the laser light source.

8. The wavelength beam combining device according to claim 6 or 7, comprising a light converger configured to converge the wavelength-combined beam reflected by the second reflective surface.

9. The wavelength beam combining device according to claim 3 or 8, wherein the light converger comprises an aspherical lens configured to converge the wavelength-combined beam.

10. The wavelength beam combining device according to any of claims 2 to 9, comprising a moving unit supporting the second diffraction grating movably in at least one of the first direction or the second direction.

11. The wavelength beam combining device according to any of claims 1 to 10, comprising:
a collimator configured to convert the plurality of laser beams into a plurality of collimated beams; and diffraction grating, and configured to reduce a distance between beam central axes of the plurality of collimated beams, and to cause the plurality of collimated beams to exit.

12. The wavelength beam combining device according to claim 11, wherein:
the optical element is a beam reducer configured to cause the plurality of laser beams to exit in parallel to each other.

13. The wavelength beam combining device according to any of claims 2 to 5 and 7, further comprising a control device configured or programmed to determine the shift amount based on the operating state of the laser light source, and to transmit the signal defining the shift amount to the movable stage.

14. The wavelength beam combining device according to any of the preceding claims, comprising the moving unit, wherein:
the moving unit is configured to move the second diffraction grating in the first direction in response to a signal defining a shift amount determined based on an operating state of the laser light source.

15. The wavelength beam combining device according to claim 14, further comprising a control device configured or programmed to determine the shift amount based on the operating state of the laser light source, and to transmit the signal defining the shift amount to the moving unit.

FIG.1

FIG.2

FIG.3A

*FIG.3B*

INTENSITY [a. u.]

LOCKED WAVELENGTH

GAIN PEAK

GAIN SPECTRUM

OUTPUT SPECTRUM

WAVELENGTH [nm]

*FIG.3C*

INTENSITY [a. u.]

LOCKED WAVELENGTH

GAIN PEAK

OUTPUT SPECTRUM

GAIN SPECTRUM

WAVELENGTH [nm]

**FIG.3D**

*FIG.4*

*FIG.5*

*FIG.6*

*FIG.7*

FIG.8

FIG.9

FIG.10

*FIG.11*

FIG.12

## FIG.13

## FIG.14

*FIG.15*

*FIG.16*

*FIG.17A*

*FIG.17B*

FIG.18

FIG.19

## FIG.20

## FIG.21A

## FIG.21B

*FIG.22A*

*FIG.22B*

FIG.23

FIG.24

FIG.25

**EUROPEAN SEARCH REPORT**

Europäisches Patentamt
European Patent Office
Office européen des brevets

**Application Number**

EP 25 21 8118

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 2023 088438 A (NICHIA KAGAKU KOGYO KK) 27 June 2023 (2023-06-27) * figures 8, 9 * * paragraph [0059] * * paragraph [0053] * * paragraph [0068] * ----- | 1-15 | INV. G02B27/10 ADD. G02B27/28 |
| Y | CN 110 927 880 A (INST MICROELECTRONICS CAS) 27 March 2020 (2020-03-27) * paragraph [0027] * ----- | 1-15 | |
| Y | CN 114 859 567 B (SUZHOU INST BIOMEDICAL ENG & TECH CAS) 3 November 2023 (2023-11-03) * paragraph [0032] * ----- | 1-15 | |
| A | Thorlabs: "Two Steering Mirrors Can be Used to Walk a Laser Beam to a New Path / Technical Resources / Insights / Lab Practices Insights / Two Steering Mirrors Can be Used to Walk a Laser Beam to a New Path", , 22 October 2020 (2020-10-22), pages 1-4, XP093365585, Retrieved from the Internet: URL:https://www.thorlabs.com/two-steering-mirrors-can-be-used-to-walk-a-laser-beam-to-a-new-path?CurrencySelect=GBPound&tabName=Insights [retrieved on 2026-02-12] * figure 1.1 * * page 4, last paragraph * ----- | 6-8 | TECHNICAL FIELDS SEARCHED (IPC) G02B |
| Y | US 2011/310356 A1 (VALLIUS TUOMAS [FI]) 22 December 2011 (2011-12-22) * paragraph [0076]; figure 2 * ----- -/-- | 10,14,15 | |

The present search report has been drawn up for all claims

| Place of search | Date of completion of the search | Examiner |
|---|---|---|
| Munich | 12 February 2026 | Navarro Fructuoso, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
...........................................................................................
& : member of the same patent family, corresponding document

EPO FORM 1503 03.82 (P04C01)

**page 1 of 2**

Europäisches
Patentamt

European
Patent Office

Office européen
des brevets

## EUROPEAN SEARCH REPORT

Application Number

EP 25 21 8118

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2020/176954 A1 (WHITMORE ALEXANDER JASON [US] ET AL) 4 June 2020 (2020-06-04)<br>* figure 1B *<br>* paragraph [0105] - paragraph [0108] *<br>----- | 12 | |
| | | | **TECHNICAL FIELDS SEARCHED (IPC)** |

The present search report has been drawn up for all claims

| Place of search | Date of completion of the search | Examiner |
|---|---|---|
| Munich | 12 February 2026 | Navarro Fructuoso, H |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

EP 25 21 8118

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2026

| Patent document cited in search report | | Publication date | Patent family member(s) | | Publication date |
|---|---|---|---|---|---|
| JP 2023088438 | A | 27-06-2023 | CN | 116262307 A | 16-06-2023 |
| | | | EP | 4198614 A1 | 21-06-2023 |
| | | | JP | 7747961 B2 | 02-10-2025 |
| | | | JP | 2023088438 A | 27-06-2023 |
| | | | JP | 2025172183 A | 20-11-2025 |
| | | | US | 2023187907 A1 | 15-06-2023 |
| CN 110927880 | A | 27-03-2020 | NONE | | |
| CN 114859567 | B | 03-11-2023 | NONE | | |
| US 2011310356 | A1 | 22-12-2011 | US | 2011310356 A1 | 22-12-2011 |
| | | | WO | 2010097505 A1 | 02-09-2010 |
| US 2020176954 | A1 | 04-06-2020 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024206299 A
- JP 2012508453 A
- JP 2021158302 A
- JP 2023088438 A
- JP 2024172262 A